# EUROPÄISCHE PATENTSCHRIFT

(11) **EP 3 997 428 B1**
(45) Veröffentlichungstag und Bekanntmachung des Hinweises auf die Patenterteilung: **29.01.2025**
(21) Anmeldenummer: 20749810.6
(22) Anmeldetag: 09.07.2020
(51) Int. Cl.: G01J 5/08, G01J 5/12, G01J 5/04, G01J 5/0802, G01J 5/10, H01L 27/146

(54) **VERFAHREN ZUM HERSTELLEN EINES HOCHAUFLÖSENDEN THERMISCHEN INFRAROT-SENSOR ARRAYS IN EINEM VAKUUMGEFÜLLTEN WAFERLEVEL GEHÄUSE**
METHOD FOR FABRICATING A HIGH-RESOLUTION THERMAL INFRARED SENSOR ARRAY IN A VACUUM-FILLED WAFER-LEVEL PACKAGE
PROCÉDÉ DE FABRICATION D'UN RÉSEAU DE CAPTEURS INFRAROUGES THERMIQUES À HAUTE RÉSOLUTION DANS UN BOÎTIER À NIVEAU DE PLAQUETTE REMPLI SOUS VIDE

(30) Priorität: 09.07.2019 DE 102019118586
(43) Veröffentlichungstag der Anmeldung: 18.05.2022
(73) Patentinhaber: Heimann Sensor GmbH, 01109 Dresden (DE)
(72) Erfinder: SCHIEFERDECKER, Jörg, 01157 Dresden (DE); HERRMANN, Frank, 01809 Dohna (DE); SCHMIDT, Christian, 01067 Dresden (DE); LENEKE, Wilhelm, 65232 Taunusstein (DE); FORG, Bodo, 55131 Mainz (DE); SIMON, Marion, 65307 Bad Schwalbach (DE); SCHNORR, Michael, 65510 Hünstetten-Wallbach (DE)
(74) Vertreter: Lippert Stachow Patentanwälte Rechtsanwälte Partnerschaft mbB
(86) Internationale Anmeldenummer: PCT/EP2020/069354
(87) Internationale Veröffentlichungsnummer: WO 2021/005150

(56) Entgegenhaltungen:
- EP-A1- 2 343 523
- CN-A- 102 583 220
- DE-A1- 102012 216 618
- US-A1- 2018 335 347

## Beschreibung

Die Erfindung betrifft ein Verfahren zur Herstellung eines hochauflösenden thermischen Infrarot-Sensor Arrays in einem vakuumgefüllten Waferlevel Gehäuse mit besonders kleinen Abmessungen, das aus mindestens zwei Wafern, einem Deckelwafer und einem zentralen Wafer mit einer Vielzahl von sensitiven Infrarot empfindlichen Sensor-Pixeln auf je einer dünnen, geschlitzten Membran über einer wärmeisolierenden Kavität besteht.

Für die Anwendungen von Infrarot-Sensor Arrays für kleine, kostengünstige Thermokameras kommt es sowohl auf ein hohes räumliches und thermisches Auflösungsvermögen als auch geringste Gehäuseabmessungen des Sensormoduls an.

Das trifft insbesondere für sogenannte mobile Anwendungen, wie z.B. in Smartphones, o.dgl. zu.

Diese Anwendungen müssen auf kleinstem Raum ein hohes thermisches Auflösungsvermögen bei guter Messgenauigkeit erreichen, und dabei geringste Gesamtabmessungen des Sensormodules aufweisen. Eine sehr geringe Bauhöhe des Infrarot-Array-Sensor-Moduls ist dabei von besonderer Wichtigkeit, um z.B. eine damit aufgebaute miniaturisierte Thermokamera im Gehäuse des Smartphones selbst unterbringen zu können. Eine Gesamtbauhöhe des Sensorarrays mitsamt der gesamten Optik von < 2,5...3 mm ist notwendig, um die Mini-Thermokamera neben der kleinen CMOS Kamera in gleicher Blickrichtung auf der Leiterplatte unterbringen zu können.

Als Infrarot-Sensor-Array kommen dafür nur thermische (ungekühlte) Sensoren in Betracht. Zu dieser Gruppe thermischer Sensoren gehören sogenannte Mikrobolometer, pyroelektrische Arrays und Thermopile-Arrays (TP-Arrays).

Um die erforderlichen Messgenauigkeiten zu erreichen, sind für pyroelektrische Arrays kontinuierlich modulierte mechanische Chopper und für Mikrobolometer sogenannte mechanische Shutter erforderlich, die zusätzlich zum Sensorarray und der Infrarotoptik in den Strahlengang eingebaut werden müssen. Die zusätzlichen mechanischen Abmessungen der gesteuerten Chopper- oder Shutterbaugruppen erhöhen die Gehäusehöhe und erschweren den Einbau in ein Smartphone-Gehäuse. Lediglich Thermopile Sensor-Arrays (TP-Arrays) erreichen die erforderlichen Messgenauigkeiten ohne zusätzliche mechanische Chopper oder Shutter im Strahlengang.

Für miniaturisierte, hochauflösende TP-Arrays müssen die Pixelabmessungen klein sein, was die hermetische Kapselung des sensitiven Arraychips unter Vakuum erfordert. Da die klassischen Gehäuse (wie Metallgehäuse, z.B. der TO-Serien) ebenfalls zu groß sind, bleibt das Waferlevel Packaging (WLP) als aussichtsreichste Variante. Das ist eine besonders kostengünstige Form der Vakuumversiegelung des Thermopile Array Chips, bei dem ein Waferverbund mit den aktiven Elementen in der Mitte unter Hochvakuum hermetisch dicht verschlossen wird.

Das WLP hat noch den weiteren Vorteil, dass alle Wafer auf Siliziumbasis den gleichen thermischen Ausdehnungskoeffizienten haben. Das heißt, wenn sich die Temperatur des Sensors beim Verpacken oder im Einsatz verändert, entsteht kein zusätzlicher Stress zwischen Deckel / Sensor und /oder Bodenwafer, da alle den gleichen Ausdehnungskoeffizienten haben.

Da einzelne Sensorpixel eines Sensorarrays nur ein sehr kleines Spannungssignal (typischerweise im µV- Bereich) liefern, müssen die Signale in der Nähe, möglichst im Sensorpackage selbst, verstärkt werden. Da sich bei einem hochauflösenden Arraysensor sehr viele Pixel auf dem gleichen Sensorchip befinden, müssen auch sehr viele (parallel arbeitende) Vorverstärker vorhanden sein.

Infrarot-Thermopile- Sensorarrays sind hinlänglich in verschiedenen Formen und Bauweisen bekannt. In Siliziummikromechanik hergestellte Thermopilesensoren bestehen meist aus einer dünnen Membran, auf der sich in Dünnschichttechnik hergestellte Thermoelemente befinden. Unter der Membran befindet sich eine Aushöhlung im Substrat.

Die "heißen" Kontakte der Thermoelemente befinden sich im Zentralteil der Membran und die "kalten" Kontakte liegen auf dem Siliziumrand, der als Wärmesenke dient. Dazwischen befinden sich beispielsweise möglichst lange schmale Beams (Stege), die den Zentralteil der Membran (Absorberbereich) mit der Wärmesenke (Si-Rand des Pixels) verbinden und ein oder mehrere Thermoelemente beinhalten.

Beiderseits der langen Beams befinden sich Schlitze, welche die Beams vom Zentralteil bzw. der Si-Senke (Tragkörper) trennen. Der größte Teil der Absorption von IR-Strahlung findet im Zentralbereich der Membran statt. Besonders bei Arrays mit hoher räumlicher Auflösung sind die Pixel klein und die Perforationen (Schlitze) sehr schmal. Um den Füllgrad des Sensors zu erhöhen, kann ein Infrarotschirm (Umbrella) über der Membran oder dem Pixel gespannt sein, um durch die größere Fläche mehr Infrarotstrahlung aufnehmen zu können.

Die Thermoelemente (auf den Beams) befinden sich relativ nah an der Si-Senke, so dass ein größerer Teil Wärme über das dazwischenliegende Gas zur Senke hin abfließen kann.

Das führt zu Signalverlust. Um dem entgegenzuwirken wird eine Vakuumversiegelung angestrebt.

Die Schlitze in der Membran werden zur Herstellung der Kavität darunter benutzt. Ein darauf gebondeter Wafer wird genutzt zur Erzeugung eines hermetisch versiegelten Verschlusses. Das isotrope Ätzen des Substrates unter der Membran erfordert allerdings einen Schutz der umliegenden Elektronik, um mögliche Schäden zu vermeiden.

In der US 2008/0128620 A1 wird ein Wafer Level Package für mehrere Thermopiles auf einer dünnen Membran beschrieben, unter oder über der sich Kavitäten zur thermischen Isolation befinden, die meist anisotrop (KOH), optional aber auch mit DRIE geätzt werden.

Die notwendige parallele Signalverarbeitung mit sehr vielen Kanälen, die notwendig wäre, um ein hochauflösendes TP - Array mit sehr vielen, kleinen Pixeln zu schaffen, ist wegen Platzmangel nicht möglich.

In der EP 2889 909 wird eine Lösung mit vielen Schlitzen im Bereich des Absorbers der Pixel vorgeschlagen, um die Si-Opferschicht unter der Membran besser aus dem Gesenk nach außen zu führen. Damit geht aber effektive Absorberfläche und somit Signal- und Messgenauigkeit verloren.

In der WO 2015004166 A1 wird eine Methode zur hermetischen Versiegelung einer elektronischen Vorrichtung mit reduziertem Stress beschrieben. Auch hier ist eine aufwendige Prozessierung zur Freilegung der Pixel nötig, und das Aufbringen von reflektierenden Metallschichten auf dem Boden der unter dem Pixel liegenden Kavität ist schwierig oder sehr aufwendig.

Keine der Lösungen erlaubt das Herstellen besonders kleiner und hochsensitiver Pixel und die Unterbringung der nötigen Signalverarbeitungskanäle auf besonders kleiner Fläche.

In der DE 10 2006 122 850 wird ein hochauflösendes Thermopile Array im WLP vorgestellt. Dieses Array hat drei miteinander verbundene Wafer (Deckel, Sensorchip und Boden).

Allerdings sind die Dicken der drei miteinander verbundenen Wafer annähernd gleich groß, d.h., der mittlere Sensorwafer mit den in Bulk-Mikromechanik mit senkrechten Löchern durch den gesamten Wafer geätzten Kavitäten begrenzen die erreichbare Pixelgröße durch einzuhaltende Toleranzen. Außerdem lassen sich nicht zu viele Pixel auf dem Sensorwafer unterbringen, weil nicht genügend Platz für die dazu nötigen parallelen Signalverarbeitungskanäle vorhanden ist.

In der US 8519336 B2 wird eine Konfiguration vorgeschlagen, bei der sich ein IR detektierendes Device über einer reflektierenden Schicht befindet. Eine arithmetische Auswerteschaltung befindet sich weiterhin auf der darunterliegenden Leiterplatte. Hier sind drei Siliziumsubstrate (Wafer) zusammengefasst. Die Empfangseinheit besteht aus einem Thermopile und einer druckreduzierten und versiegelten Grube in einem Siliziumsubstrat. Die reflektierende Schicht bildet eine Art Nische unterhalb der Empfangseinheit. Die Oberfläche der Nische besteht aus einem reflektierenden Material, wie z.B. Gold oder Aluminium. Durch diese Anordnung wird IR-Strahlung, welche nicht primär in der Empfangseinheit detektiert wurde, reflektiert und wieder zurück auf die Empfangseinheit fokussiert zur erneuten Möglichkeit der Detektion.

Die "Nischen" mit den reflektierenden Strukturen haben eine parabolspiegelartige Ausformung, damit ein möglichst hoher Anteil der IR-Strahlung auf die Empfangseinheit zurück reflektiert werden kann.

Die notwendigen elektrischen Kontakte erstrecken sich von der Rückseite des oberen Wafers zur Vorderseite des mittleren Wafers durch an sich bekannte sogenannte Through-Silicon Vias (TSVs, d.h. Durchkontaktierungen) durch den mittleren Wafer im "3-Wafer-Sandwich" bis zur Rückseite des Wafers und zu einer Signalverarbeitungseinheit und schließlich weitere Vias zur Rückseite des Bodenwafers und zu Lötkontakten. Damit wird dieses Thermopile Array im WLP SMD fähig.

Damit können die Signalleitungen prinzipiell sowohl außerhalb des Pixelbereiches oder auch zwischen den Pixeln geführt werden, wobei die Signalverarbeitungen für jeden Pixel im Bodenwafer unter den Pixeln durchgeführt werden kann.

Typische, nach dem gegenwärtigen Stand der Technik hergestellte TSVs benötigen laterale Abmessungen, auf dem Wafer, die etwa bei einem Zehntel der Waferdicke liegen. Folglich wären typische Vias bei einer Waferdicke von 400 ...500 µm etwa 40...50 µm groß.

Damit lassen sich keine räumlich besonders hochauflösenden Arrays mit besonders kleinen Pixeln herstellen, weil allein die Größe der Vias im Feld der Pixel die lateralen Pixelabmessungen vergrößert.

Für Arrays als kleines Kamerachip in einem Smartphone ist das aber zu viel, denn über dem Sensor Array Chip muss ja auch noch eine Linsenoptik mit entsprechender Brennweite montiert werden.

Aus der CN 102 583 220 B geht ein Infrarotdetektor hervor, der aus einem ersten Si-Substrat besteht, auf dem sich eine Passivierungsschicht mit einer CMOS Schaltung befindet, sowie eine Infrarot absorbierende Schicht auf einer Membran über einer Vertiefung (Sensor Pixel) und einem zweiten Substrat, das mit einer Vertiefung über der IR absorbierenden Schicht/Membran versehen ist.

Seitlich der Membran befinden sich Durchkontaktierungen, die durch Tiefenätzen und eine Metallfüllung hergestellt worden sind. Um die Durchkontaktierung freizulegen, wird das Substrat auf der Rückseite abgedünnt, was jedoch keinen Einfluss auf die Größe der Pixel hat.

Die DE 10 2012 216 618 A1 betrifft eine Anordnung von mindestens zwei Wafern zum Detektieren elektromagnetischer Strahlung, bestehend aus einem ersten Wafer einem Array von Infrarot Sensorelementen (Sensor Pixel), einem zweiten Wafer mit einer integrierten Auswerteschaltung, die mit dem Sensorarray über Durchkontaktierungen verbunden ist. Weiterhin ist ein dritter Wafer vorgesehen, der als Kappenwafer dient und der das Sensorarray auf dem ersten Wafer abdeckt.

Damit soll eine Trennung von ASIC- und MEMS-Strukturen erreicht werden, indem diese auf unterschiedlichen Wafern realisiert werden. Für die elektrische Verbindung sind Durchkontaktierungen vorgesehen. Maßnahmen zu Herstellung besonders kleiner Sensor Pixel werden nicht beschrieben.

Keine der Lösungen nach dem Stand der Technik erlaubt die Herstellung eines hochauflösenden Infrarotsensorarrays mit sehr vielen, sehr kleinen Pixeln und einer besonders geringen Aufbauhöhe (dass sie z.B. in ein Smartphone o.ä. passen), das in einem normalen, CMOS-kompatiblen Prozess einfach herstellbar ist.

Die Empfindlichkeit eines Infrarotsensors ist auch abhängig von der Wärmeableitung über das Gas, welches den Sensor umgibt und kann über eine vakuumdichte Verpackung erhöht werden. In einem vakuumdichten Gehäuse sind Signalverluste durch die Wärmeleitung über das Gas nicht vorhanden oder sehr gering. Gebräuchliche Vakuumgehäuse in der Aufbau- und Verbindungstechnik sind allerdings material- und kostenaufwendig, um die nötige Vakuumdichtheit zu erreichen. Schon das normale Chipkleben kann hier zum Kosten- und Problemfaktor werden aufgrund von Ausgasungen und Undichtigkeit. Da die einzelnen Materialien des Gehäuses üblicherweise unterschiedlich sind (Boden, Kappe, optisches Fenster), haben sie auch unterschiedliche thermische Ausdehnungskoeffizienten, die zu mechanischem Stress und zu Undichtigkeiten führen kann.

Ein Verpacken und vakuumdichtes Versiegeln auf Waferlevel ist kostengünstig und lässt sich massentauglich realisieren. Durch das Verkapseln des Thermopilesensor-Wafers mit einem Deckel- und einem Unterbodenwafer wird die nötige Vakuumdichtheit erreicht.

Ein Nachteil der bekannten Wafer Level Packages (WLP) für Thermopile Array liegt in der recht großen Bauhöhe, die sich durch den Verbund mehrerer Einzel-Wafer ergibt. Denn jeder der einzelnen Wafer, muss bearbeitet werden, er bekommt Kavitäten, Metallisierungen, Filterschichten oder dgl. Das erfordert bei den Größen moderner Halbleiter-Wafer (die bei 200 und 300 mm Durchmesser liegen) eine gewisse Mindestdicke des Wafers. Wäre er zu dünn (z.B. nur 100...200 µm), würde er bei den meisten in Produktion befindlichen Anlagen bei der Prozessierung (Handhabung) zerbrechen.

Waferdicken von ca. 400...500 µm sind gegenwärtig typisch und mit vertretbarer Ausbeute in Serienfertigung bearbeitbar. Ein Verbund von 2 Wafern hat dann schon ca. 0.8 - 1 mm Dicke, bei 2 Verbundwafern und ca. 1,2...1,5 mm bei einem Verbund von drei Wafern (die besonders bevorzugte Variante mit Bulk Mikromechanik wie in den bekannten Lösungen.) Das verhindert das Erreichen einer sehr geringen Bauhöhe (z.B. für den Einsatz in Smart Phones).

Ein zweiter Nachteil des Standes der Technik ist die geringe räumliche Auflösung durch zu große Thermopile Pixel. Die kleinsten bisher bekannt gewordenen Thermopile Arrays haben Pixelabmessungen von 90 µm.

Ein dritter Nachteil bekannter thermischer Infrarot- Array Lösungen (z.B. Thermopile Arrays) besteht in der großen lateralen Baugröße, was ebenfalls die Unterbringung in kleinen mobilen Geräten wie Smartphones erschwert. Meist werden die Sensor Array Chips in metallische TO-Gehäuse oder Metall-Hermetikgehäuse montiert, deren Außenabmessungen deutlich größer sind als das Sensorchip selbst.

Aufgabe der Erfindung ist es, ein Verfahren zum Herstellen eines hochauflösenden thermischen Infrarot-Sensor Arrays in einem vakuumgefüllten Waferlevel Gehäuse in monolithischer Silizium-Mikromechanik- Technologie im Wafer Level Package anzugeben, das ein besonders hohes räumliches Auflösungsvermögen (durch sehr kleine Pixel) und einen sehr hohen Füllgrad bei kleinsten Gehäuseabmessungen, insbesondere sehr geringer Gesamtdicke erreicht und mit Standard- CMOS- kompatiblen Prozessen kostengünstig hergestellt werden kann.

Die der Erfindung zugrundeliegende Aufgabe wird durch die Merkmale des Hauptanspruchs gelöst. Weitere Ausgestaltungen der Erfindung gehen aus den zughörigen Unteransprüchen hervor.

Erfindungsgemäß wird die Aufgabe dadurch gelöst, dass mindestens zwei, bevorzugt drei oder mehr Halbleiterwafer, z.B. aus Silizium oder infrarotdurchlässigem Glas für den Deckelwafer, zuerst getrennt bearbeitet und anschließend montiert und dabei schrittweise abgedünnt werden:
- Der Deckelwafer wird auf der Unterseite bevorzugt mit einer Kavität von einigen 10 bis einigen 100 µm versehen und anschließend beide Waferseiten mit sogenannten Antireflex- oder Filterschichten versehen. Diese Filterschichten sollen einerseits eine besonders hohe Transmission des Deckelwafers für den Infrarotbereich ermöglichen und zusätzlich bestimmte Spektralbereiche ausblenden können, in denen beispielsweise Transmissionsverluste in der Atmosphäre vorliegen, die zu Abstandsabhängigkeit bei der Messung entfernter Objekte führen würden.

Diese Filterschichten können auch aus speziellen Subwellenlängenstrukturen bestehen.
- Die Tiefe der Kavität kann z.B. etwa die Hälfte der Gesamtdicke des Deckelwafers ausmachen, weil sich dadurch auch die Transmission des Wafers für die IR-Strahlung erhöht. Zu gering darf die Restdicke aber nicht werden, damit der Waferverbund mechanisch stabil bleibt.

Der mittlere Wafer bzw. der Wafer mit den Sensorpixeln wird mit den an sich bekannten Funktionsschichten versehen. Dazu gehören z.B. mehrere Layer aus polykristallinem oder amorphem Silizium unterschiedlicher Leitfähigkeit), Absorberstrukturen (bevorzugt sogenannte Umbrellas) und CMOS-Strukturen für die Signalverarbeitung. Alle oberflächenseitigen Schritte (wie das Einbringen der späteren Schlitze in der Membran für die thermische Isolation vom Si-Substrat) müssen vor dem Fügen erfolgt sein.

Der mittlere Sensorwafer hat erfindungsgemäß nach dem Abdünnen eine sehr geringe Restdicke von < 200...300 µm, bevorzugt < 50-100 µm. Dies erlaubt gegenüber bisher bekannten Thermopile Array Lösungen zwei Vorteile.

Einerseits können viel kleinere Thermopile Pixel als bisher bekannt prozessiert werden, weil die nach dem DRIE Ätzprozess verbleibenden Si-Ränder der Pixel (die zur thermischen Trennung und als Wärmesenke für die kalten Kontakte agieren) auf wenige Mikrometer reduziert werden können.

Andererseits können auch viel kleinere laterale Abmessungen für elektrische Durchkontaktierungen von der Vorderseite zur Rückseite des Thermopile-Wafers (oder des Bodenwafers) realisiert werden, als sie bei Standard-Waferdicken von z.B. ca. 400 - 500 µm Dicke möglich wären.

Beim gegenwärtigen Stand der Technik betragen typisch erreichbare laterale Abmessungen von TSV etwa ein Zehntel der Waferdicke. Folglich wären typische Vias bei einer Waferdicke von 400 µm etwa 40 µm groß. Wäre der Wafer aber auf z.B. 30 µm abgedünnt, so wären die Vias nur noch etwa 3 µm groß. Dadurch können in weiterführenden Ausführungsformen selbst bei besonders kleinen Thermopile Pixelabmessungen noch jeder Pixel zur Rückseite verbunden werden.

Die Vorbereitung der elektrischen Kontakte zur äußeren Weiterverarbeitung der Sensorsignale von den Arraypixeln umfasst:
Entweder der mittlere Wafer mit den Sensorpixeln und einem Teil der Signalverarbeitungselektronik wird über vorbereitete Bondpads im mittleren Wafer und spätere Drahtbrücken direkt nach außen geführt, oder
die Signalverarbeitung wird zum Bodenwafer durchgeleitet, z.B. über sehr kleine Vias (sogenannte Through-Silicon Vias, TSVs). Auf dem Bodenwafer kann die weitere Signalverarbeitung (ROIC) untergebracht werden. Dort ist mehr Platz als neben dem Thermopile Array auf dem mittleren Wafer.

Im Maximalfall wird sogar jeder Pixel einzeln zum Bodenwafer durchgeleitet. Das wird auf Grund des besonders dünnen zentralen Wafers möglich, der sehr kleine und besonders präzise Durchkontaktierungen in den Ecken der Pixel erlaubt und somit die Packungsdichte des Arrays weiter erhöht.

Auf dem unteren Bodenwafer (ROIC) können neben der Signalverarbeitung wie Vorverstärker und Analog-Digitalwandler auch ein Großteil der digitalen Signalaufbereitung, bis hin zur Bildauswertung in Form von Prozessoren untergebracht werden.

Um Signale weiter nach unten zum Trägersubstrat zu bringen, können sich im Bodenwafer weitere Vias/Durchkontaktierungen befinden, um Signale direkt nach unten auf geeignete Kontakte wie Lotbumps leiten zu können.

Die Justage auf den thermal pads eines Quad Flat No Leads Package (QFN Packages) kann auch dafür nützlich sein, um ungewollt entstehende Wärme im ASIC abzuleiten.

Im Deckelwafer befindet sich eine Grube, die mittels geeigneter Methoden, wie Nassätzen oder DRIE, eingetrieben wurde. Die Grube soll aus Gründen der mechanischen Stabilität nicht mehr als 50% so tief wie die Dicke des Deckelwafers sein.

Der Bodenwafer (ROIC) kann in einer Variante auch sehr stark auf < 0,2 ... 0,3 mm abgedünnt werden, damit der Gesamtstapel aus drei Wafern so dünn wie möglich wird um in eine mobile Einrichtung, wie ein Smartphone, zu passen.

Die Erfindung wird nachfolgend an einem Ausführungsbeispiel näher erläutert. In den zugehörigen Zeichnungsfiguren zeigen:
- Fig. 1:: den prinzipiellen Aufbau eines erfindungsgemäßen, sehr dünnen Infrarot Sensor Arrays im Vakuum Wafer Level Package als Schnittdarstellung;
- Fig. 2:: die Vorbereitung des Deckelwafers, Sensorwafers und Bodenwafers als Einzelwafer vor der Montage im Wafer Level Package;
- Fig. 3:: die einzelnen Montageschritte der Einzelwafer zu einem erfindungsgemäßen, dünnen Waferverbund im Wafer Level Package mit von der Rückseite her freigeätzten Kavitäten unter den Pixeln im Sensorwafer;
- Fig. 4:: eine Ausgestaltung eines sehr dünnen thermischen Arraychips im WLP das ohne Durchkontaktierungen (TSVs) auskommt;
- Fig. 5:: eine Ausgestaltung eines sehr dünnen thermischen Arraychips im WLP mit vorderseitig freigeätzten Kavitäten im Sensorwafer;
- Fig. 6:: eine besonders vereinfachte Ausgestaltung eines sehr dünnen Thermopile Arrays im Waferlevel Gehäuse mit nur zwei Wafern;
- Fig. 7:: eine Ausgestaltung eines sehr dünnen thermischen Arrays zu einem oberflächenmontierbaren Gehäuse (SMD-fähiges Gehäuse);
- Fig. 8:: eine weitere Ausgestaltung eines Thermopile Arrays mit einem zusätzlichen Bodenwafer, der weitere Signal- oder Bildverarbeitungskomponenten enthält; und
- Fig. 9:: eine Ausgestaltung eines sehr dünnen Infrarot Arrays mit einer geflippten Montage des Thermopile Wafers.

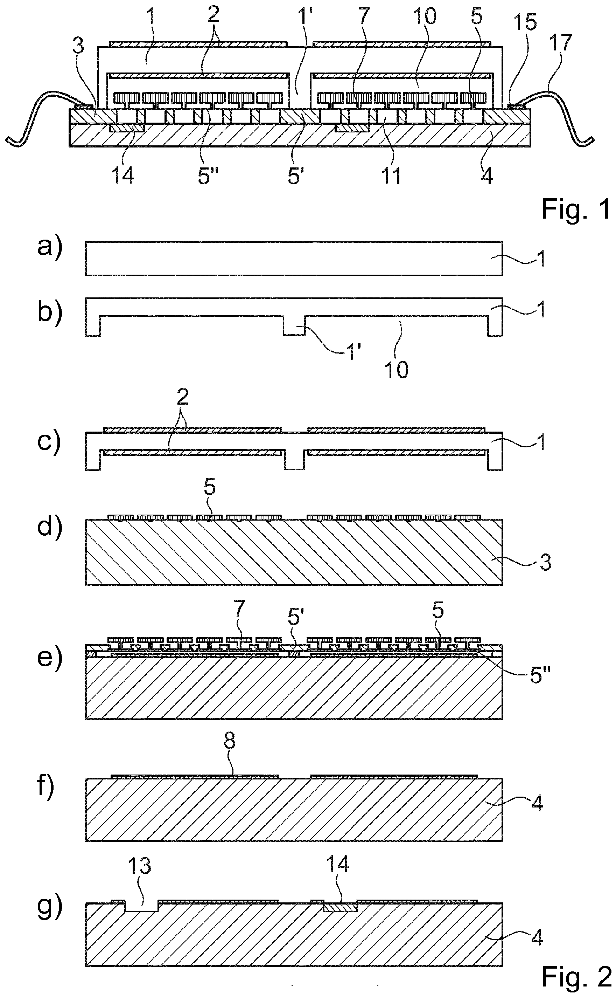

Es versteht sich, dass in den Fig. 1 bis 9 nur jeweils ein Ausschnitt der verschiedenen Wafer dargestellt ist und dass die Wafer tatsächlich flächenmäßig viel größer sind und jeweils eine Vielzahl der beschriebenen Strukturen nebeneinander enthalten, die nach der Fertigstellung durch Sägen in einzelne thermische Infrarot Sensorarrays vereinzelt werden.

Fig. 1 zeigt den prinzipiellen Aufbau eines sehr dünnen Infrarot Sensor Arrays im Vakuum Wafer Level Package mit einem oberen Deckelwafer 1, einem abgedünnten zentralen Wafer 3 und einem Bodenwafer 4 nach der jeweiligen Wafermontage, jedoch noch vor dem Vereinzeln. Im Deckelwafer 1 befindet sich jeweils über einer Gruppe von Sensor-Pixeln 5 eine Kavität 10.

Das Infrarot Sensorarray enthält nach Fig. 1 mehrere Gruppen von Infrarot-Sensor Arrays mit mehreren Sensor-Pixeln 5, nebeneinander, oder in Vierer- oder mehr Gruppen in regelmäßiger Verteilung, wobei zwischen den Gruppen schmale Streifen 5' auf dem zentralen Wafer 3 ohne Sensor-Pixel 5 freigehalten sind und wobei sich über jeder Gruppe von Sensor-Pixeln 5 jeweils eine Kavität 10 im Deckelwafer 1 befindet. Die einzelnen Kavitäten 10 werden durch Stege 1' voneinander getrennt, die sich jeweils auf einem Streifen 5' abstützen und den Deckelwafer 1 mechanisch stabilisieren.

Beispielsweise können vier Gruppen von Sensor-Pixeln 5 in Quadranten flächig verteilt auf dem zentralen Wafer 3 angeordnet sein, so dass sich die Streifen 5' sich kreuzförmig schneiden. Die Kavitäten 10 im Deckelwafer 1 sind dann entsprechend anzuordnen, so dass sich die Stege 1' ebenfalls kreuzförmig schneiden und sich auf den Streifen 5' des zentralen Wafers 3 abstützen.

Die auf einem zentralen Wafer 3 maximal realisierbare Anzahl von Sensor-Pixeln 5 bzw. von entsprechenden Gruppen ist nur durch die Größe der Sensor-Pixel 5 und den lateralen Abmessungen der Wafer begrenzt.

Der Deckelwafer 1 mit Filterschichten 2 ist am dicksten und verleiht dem zu schaffenden Waferverbund zusammen mit den sich auf den Streifen 5' abstützenden Stegen 1' seine Stabilität. Der zentrale Wafer 3 enthält eine Vielzahl von thermischen Sensor-Pixeln 5 und Kavitäten 11 im zentralen Wafer 3 unter jedem Sensor-Pixel 5, die jeweils durch eine Membran 5" begrenzt werden, die mit dem umgebenden zentralen Wafer 3 verbunden ist. Auf jeder Membran 5'' befindet sich ein IR-Strahlungsabsorber in Form eines Umbrellas 7 (Fig. 2). Die Kavitäten 11 werden seitlich durch im Wesentlichen senkrechte Wände im zentralen Wafer 3 und zeichnungsgemäß oben durch die Membran begrenzt.

Diese Erläuterungen gelten grundsätzlich auch für die weiterhin beschriebenen Ausführungsformen, um Wiederholungen zu vermeiden.

Der Bodenwafer 4, der mit einem eingebrachten Gettermittel 14 unter jeder Gruppe von Sensor-Pixeln 5 versehen ist, wurde nach der jeweiligen Montage stark abgedünnt auf typisch <50...100 µm Dicke. Die Sensor-Pixel 5 mit den Kavitäten 10 und 11, welche die Sensor-Pixel 5 thermisch isolierend umgeben, werden beim Verschluss unter Vakuum Atmosphäre hermetisch dicht eingeschlossen. Bei Bedarf werden durch Zünden des Gettermittels 14 die Auswirkungen von Ausgasungen auf das stabile Vakuum unterdrückt.

Für die Übertragung der von den Pixeln 5 erzeugten elektrischen Signale befinden sich auf dem Bodenwafer 4 im Randbereich außerhalb des Deckelwafers 1 Kontaktpads 15 für Drahtbrücken 17.

In Fig. 2 ist ein Verfahren zur Vorbereitung der drei Teilwafer (Deckelwafer 1, zentraler Wafer 3, Bodenwafer 4) auf die Wafermontage (WLP) dargestellt.

Im ersten Schritt wird ein beidseitig polierter Silizium-Wafer (Fig. 2a), der spätere Deckelwafer 1, wie vorstehend beschrieben, mit den Kavitäten 10 versehen (Fig. 2b) und anschließend mit beidseitigen Antireflex oder Filterschichten 2 beschichtet Fig. 2c). Diese Filterschichten 2 könnten auch auf Linsen einer Optik aufgetragen werden, die sich über den Kavitäten 10 befinden können. Aber der Kostenaufwand ist bei den einzelnen Linsen deutlich höher als bei Filtern im Waferverbund.

Auf dem zentralen Wafer 3, dem Sensorwafer, werden die Sensor-Pixel 5 erzeugt (Fig. 2d) und vorzugsweise mit zusätzlichen dreidimensionalen Absorberstrukturen, den Umbrellas 7 auf den Membranen 5'', zur Erhöhung des Füllfaktors auf den Sensor-Pixeln 5 (Fig. 2e) versehen, indem sich die Umbrellas 7 flächenmäßig über die Abmessungen der darunter befindlichen Membranen 5" hinaus erstrecken, ohne benachbarte Umbrellas 7 zu berühren.

Auf der Oberseite des Bodenwafers 4 werden weitere CMOS-Strukturen 8 integriert (Fig. 2f) und für jeden Chip (d.h. für jede Gruppe von Sensor-Pixeln 5) mindestens eine Kavität 13 im Bodenwafer 4 für das Einbringen des Getters 14 (Fig. 2 g) geschaffen. Da die Herstellung der CMOS-Strukturen 8 bestens bekannt ist, wird hierauf nicht weiter eingegangen.

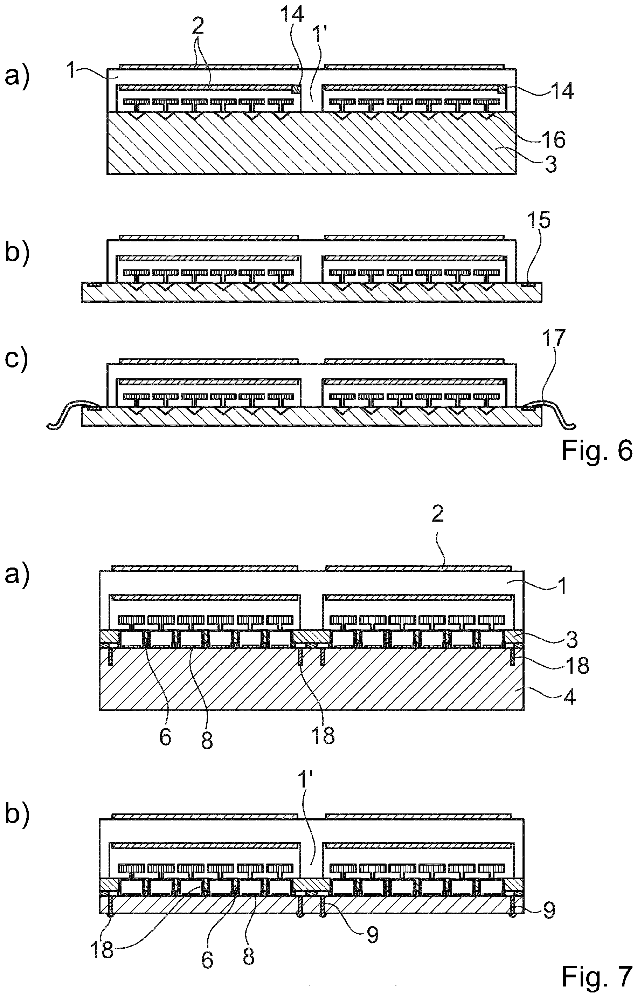

Die CMOS-Strukturen 8 enthalten CMOS Auswerteschaltungen und ggfs. weitere Schaltungen zur Signalbearbeitung bis hin zu Bildprozessoren. Besonders vorteilhaft ist auch die Integration eines EEPROMS, um später Mess- und Kalibrierwerte der einzelnen Sensorpixel 5 im Infrarot Sensor Array selbst zu speichern. Außerdem wird der zentrale Wafer 3 vorzugsweise mit Durchkontaktierungen 6 (Fig. 7) von der CMOS Seite mit elektrischen Anschlüssen zur Waferunterseite versehen.

An einer Stelle unterhalb des späteren Pixelbereiches wird im Bodenwafer 4 bzw. unter jeder Gruppe von Sensor-Pixeln 5 vorzugsweise eine Kavität 13 durch einen üblichen Silizium-Nass- oder Trockenätzschritt eingebracht und in dieser das Gettermittel 14 abgeschieden, um ein langzeitstabiles Vakuum herstellen zu können. Dieser Bereich kann klein sein und sowohl unter als auch neben den Pixeln liegen, muss aber über ein oder mehrere geätzte Löcher in der Membran 5" mit der Vorderseite des zentralen Wafers 3 verbunden sein.

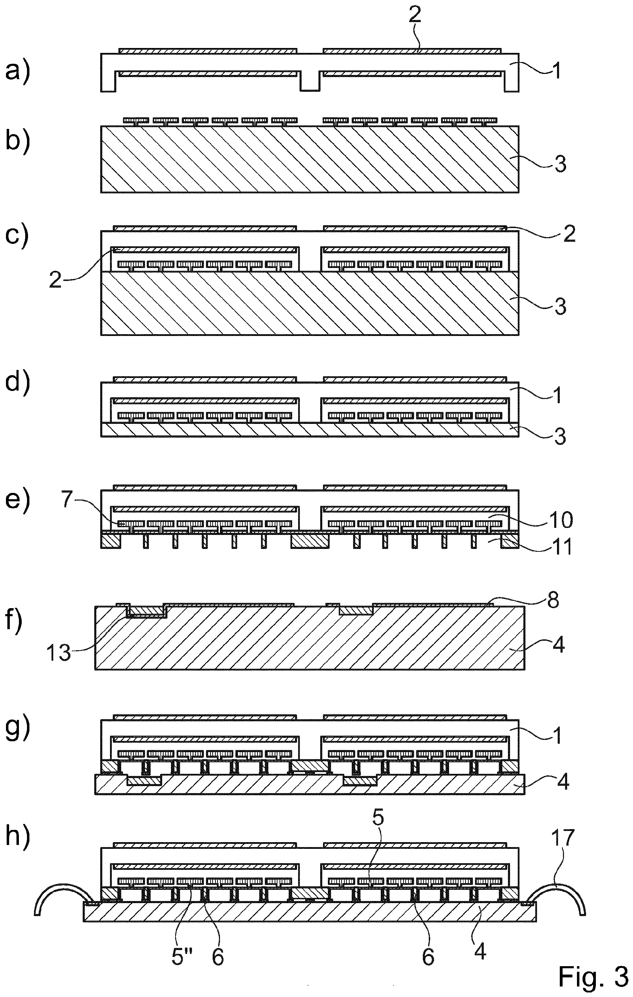

Die Montage der drei Einzelwafer zu einem kompletten Waferstapel in einer ersten Ausführungsform zeigt Fig. 3, mit den Montageschritten der drei Einzelwafer zu einem dünnen Waferverbund im Wafer Level Package mit von der Rückseite geätzten Kavitäten 11 im zentralen Wafer 3 unter den Sensor-Pixeln 5.

Der Deckelwafer 1 und der zentrale Thermopile Wafer, d.h. der zentrale Wafer 3 (Fig. 3a), werden zu festem Verbund gefügt (Fig. 3c), z.B. durch Waferbonden oder Kleben. Danach folgen das Abdünnen des Sensor-Wafers 3 (Fig. 3d) von der Rückseite bzw. Unterseite und ein Tiefenätzschritt in den Sensor-Wafer 3 (Fig. 3e) zur Herstellung jeweils einer Kavität 11 unter jedem Pixel 5, sowie die Justage und Montage des Bodenwafers 4 am zentralen Wafer 3 (Fig. 3f). Schließlich erfolgt ein Abdünnen des Bodenwafers 4 (Fig. 3g) ebenfalls von der Rückseite, sowie die elektrische Kontaktierung (Fig. 3h) der fertigen Sandwichanordnung mit einem Verdrahtungsträger durch Drahtbrücken 17, oder alternativ über Durchkontaktierungen 6 zwischen den Sensor-Pixeln 5 (Fig. 7).

Obwohl auch andere thermische Sensorverfahren, wie pyroelektrische oder bolometrische Sensorpixel möglich sind, wird in der Folge das Sensorprinzip am Beispiel eines Thermopile-Pixels beschrieben, deren Konstruktion grundsätzlich bekannt ist.

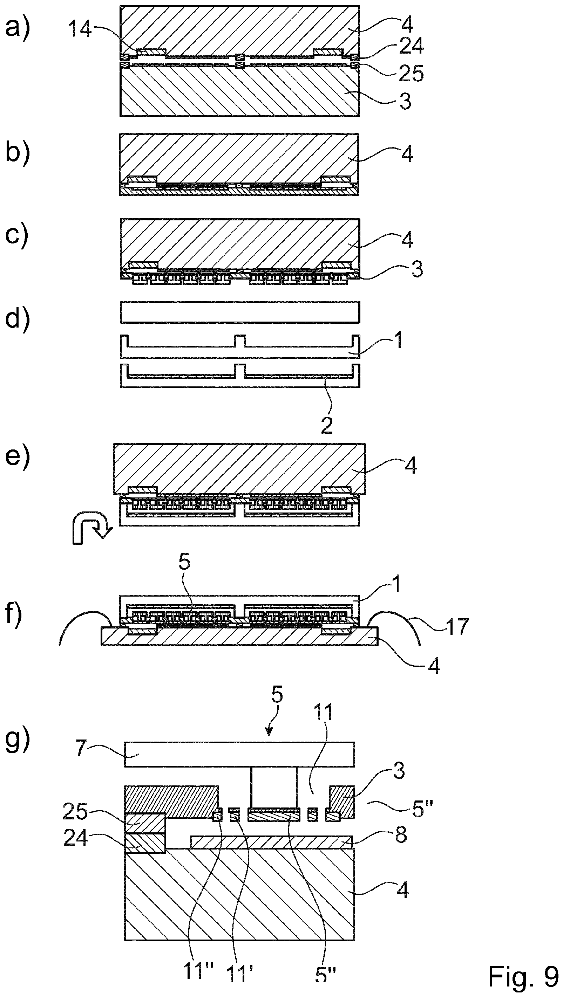

Der Vollständigkeit halber soll jedoch erwähnt werden, dass die Umbrellas 7 auf den Membranen 5'' im Unterschied zu Fig. 1 über den Kavitäten 11 mittels schmaler Beams 11', aufgehängt sind, wie aus Fig. 9g ersichtlich ist, wobei zwischen den Beams 11' und der Membran 5" sowie zwischen den Beams 11' und dem die Kavitäten 11 seitlich umgebenden Rand des zentralen Wafers 3 Schlitze 11'' zur thermischen Isolation ausgebildet sind. Über die Beams 11' erstrecken sich bei Thermopile-Pixeln thermophile Strukturen, deren "heiße" Kontakte sich auf der Membran 5" befinden und deren "kalte" Kontakte auf dem die Kavitäten 11 umgebenden Rand, der als Wärmesenke fungiert.

Es soll weiterhin erwähnt bleiben, dass diese spezielle Variante durch eine Zusammenfügung des geflippten späteren Bodenwafers 4 auf dem Thermopile-Wafer entsteht, wobei die Unterseite der Membran 5'' des geflippten Waferverbundes (Fig. 9f, g) aufgebracht worden sind.

Bei der Montage werden im ersten Hauptschritt der Deckelwafer 1 mit den Kavitäten 10 und den aufgetragenen Filterschichten 2 gegenüber dem zentralen Wafer 3 (Fig. 3b) justiert, so dass die sensitiven Sensor-Pixel 5 mit den entsprechenden auf diesen befindlichen Absorberschichten, (z.B. Umbrellas 7 über den Membranen 5'') in die Kavität des Deckelwafers 10 hineinragen können.

Die Justage der drei Wafer kann über trocken- oder nassgeätzte Strukturen im Deckelwafer 1 erfolgen, beispielsweise mittels eines geeigneten Infrarot-Mikroskops.

Beide Wafer (Deckelwafer 1 und zentraler Wafer 3) werden mechanisch fest und hermetisch dicht miteinander verbunden (Fig. 3c). Dies geschieht durch an sich bekannte Verfahren des eutektischen Waferbondens (z.B. anodisches Bonden, Löten, oder Aufschmelzen von Glasfritte, Kleben oder Schweißen). Auch wenn das Glasfritte-Verfahren aufgrund des Bekanntheitsgrades bevorzugt wird, so bietet auch das eutektische Bondverfahren, insbesondere das SLID-Verfahren unter Ausnutzung der Flüssig-Festphasen-Diffusion, durchaus Vorteile. Die Bondtemperatur liegt teils deutlich unter 400°C und ist somit voll CMOS-kompatibel. Die Auswahl der Materialien muss natürlich entsprechend der nötigen CMOS-Kompatibilität sorgfältig erfolgen.

Ein flüssiges Eutektikum bildet sich beim Bonden an der Grenzfläche zwischen beiden Wafern aus. Während des Abkühlvorgangs entsteht dann eine stoffschlüssige Verbindung zwischen den Wafern. Aufgrund dieser stoffschlüssigen Verbindung ist neben einer sehr guten hermetischen Dichtigkeit die Stabilität des hergestellten Stapels sehr hoch, was von Vorteil für die folgenden Prozessschritte ist.

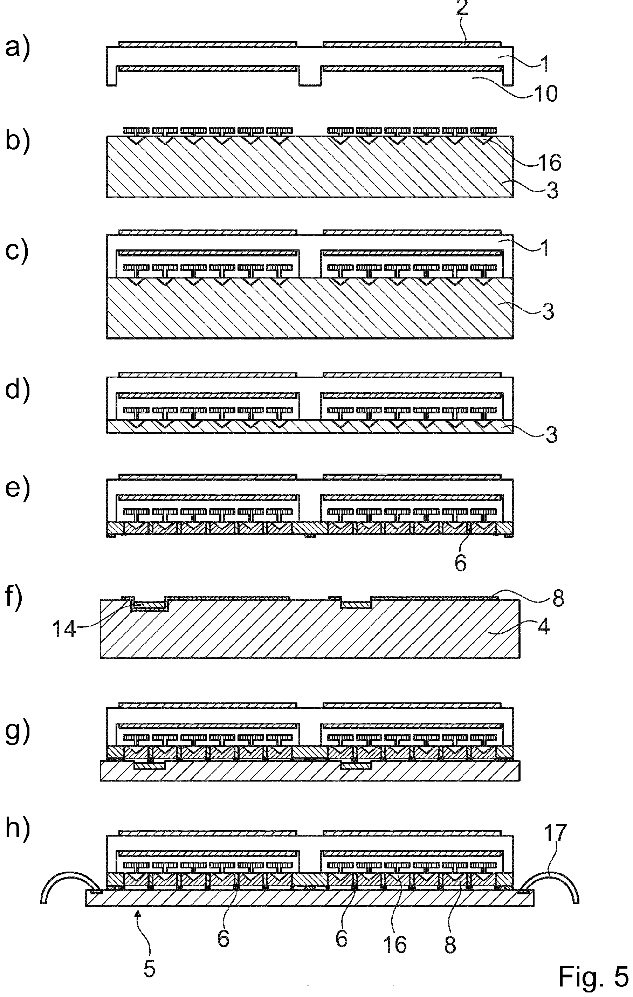

Anschließend wird die Rückseite des zentralen Wafers 3 (z.B. durch mechanische Verfahren, wie Schleifen und Polieren) abgedünnt, siehe Fig. 3d. Die verbleibende Dicke des zentralen Wafers 3 bzw. des Wafers mit den Sensorpixeln 5 sollte nicht mehr als 200 µm betragen, besser jedoch <20...50 µm, bevor von der Rückseite die Membranen 5" unter den Sensor-Pixeln 5, z.B. durch Trockenätzen (DRIE) frei geätzt werden und dadurch die wärmeisolierenden Kavitäten 11 (siehe Fig. 3 e) entstehen. Dabei können auch die Durchkontaktierungen 6 (sog. Vias 6 - siehe z.B. in Fig. 5, 7 oder 8), vom zentralen Wafer 3 zum Bodenwafer 4 mit den weiteren Baugruppen der CMOS Signalverarbeitung 8 formiert werden. Auch für die Durchkontaktierungen 6 ergibt sich, dass diese durch den oder die stark abgedünnten zentralen Wafer 3 mit deutlich kleineren lateralen Abmessungen und präziser hergestellt werden können.

Das Abdünnen vor dem DRIE Ätzvorgang und dem Herstellen der Durchkontaktierungen 6 hat mehrere wichtige Funktionen im Sinne der Erfindung:
- Die Dicke des zentralen Wafers 3 von typisch 400 - 500 µm kann auf sehr geringe Substratdicken von anspruchsgemäß < 200 µm und bevorzugt <20...50 µm reduziert werden, was die Dicke des Gesamtaufbaus verringert.
- Das sehr dünne Restsubstrat des zentralen Wafers 3 kann durch DRIE - Ätzen wesentlich präziser durchgeätzt werden, weil die Toleranzen beim Ätzprozess (sogenannter Tilt) natürlich mit abnehmender Waferdicke keinen oder nur noch wenig Einfluss auf die Übertragungsgenauigkeit der für das Ätzen verwendeten Ätzmaske haben. Mittels DRIE wird die Ätzmaske auf die dem oberen Deckelwafer 1 zugewandte Seite mit sehr hoher Genauigkeit übertragen, so dass sehr kleine Pixelstrukturen möglich sind.
- Die laterale Größe der Durchkontaktierungen 6 kann auf Grund des sehr dünnen zentralen Wafers 3 sehr deutlich verringert werden.
- Der DRIE Ätzprozess (üblicherweise meist als Einscheibenprozess ausgeführt) ist dieser aufgrund geringer Ätztiefe schneller und damit wesentlich kostengünstiger möglich.

Im nächsten Montageschritt wird der Bodenwafer 4 mit der CMOS Schaltung 8 auf der Vorderseite und den Kavitäten 13 für das Gettermittel 14 voran zu den beiden bereits aufeinander montierten oberen Wafern (Deckelwafer 1 und zentraler Wafer 3) justiert (Fig. 3f) und durch Waferbonden mechanisch fest verbunden. Anschließend wird auch dieser Bodenwafer 4 bulkseitig (rückseitig) abgedünnt (Fig. 3g), und die evtl. benötigten oder vorhandenen elektrischen Durchkontaktierungen 6 (sogenannte Through-Silicon-Vias, TSV) 6 formiert und kontaktiert.

Um eine möglichst hohe Temperaturauflösung zu erreichen, sollte der zentrale Wafer 3 hermetisch dicht in Vakuumatmosphäre eingeschlossen sein. Dies kann bereits beim normalen Waferlevel Package erfolgen.

Während ein zusätzliches Gettermittel nicht zwangsläufig erforderlich ist, so hat sich doch gezeigt, dass ein eingebrachtes Gettermittel 14, das bevorzugt durch thermische Anregung "Aufheizen" beim Waferbonden oder danach aktiviert wird, ein langzeitstabiles Vakuum unterstützt. Auch elektrisch aktivierte Gettermittel 14 sind möglich, dafür müssen entsprechende Zuleitungen in den Bodenwafer 4 eingebracht werden.

Das Gettermittel kann prinzipiell auch im Deckelwafer 1 (siehe Fig. 6a) oder am Rande des zentralen Wafers 3 neben den Sensor-Pixeln 5 untergebracht werden. Da der zentrale Wafer 3 aber funktionsgerecht Löcher haben muss (durch Schlitze 11'' in der Membran 5'' und Löcher im Substrat), ist es die eleganteste und bevorzugteste Methode, das Gettermittel 14 in den Bodenwafer 4 unterhalb der Sensor-Pixel 5 unterzubringen. Denn die Anordnung der Schlitze 11" und Löcher im zentralen Wafer 3 gestatten auf einfache Weise den Gasaustausch von der Ober- zur Unterseite.

In einem letzten Schritt wird der Sandwich aus den verbundenen und abgedünnten drei Wafern nach dem Vereinzeln in einzelne getrennte Array Chips auf einem (in Fig. 3h) nicht dargestellten) Verdrahtungsträger montiert und elektrisch beispielsweise über Drahtbondbrücken 17 kontaktiert (Fig. 3h). Ein solcher Verdrahtungsträger kann sowohl eine Leiterplatte (PCB, z.B. die Leiterplatte in einem Mobile Phone), ein Metallgehäuse oder ein sogenanntes QFN Gehäuse mit sehr dünnem Boden sein.

Dadurch kann der Gesamtverbund der einzelnen Wafer erfindungsgemäß nicht wesentlich dicker sein als ein einzelner Wafer. Denn als gemeinsamer Verbund von beispielsweise nur noch 500 µm Dicke lässt er sich gut handhaben (bearbeiten, vermessen und transportieren) und in einzelne Chips zerteilen.

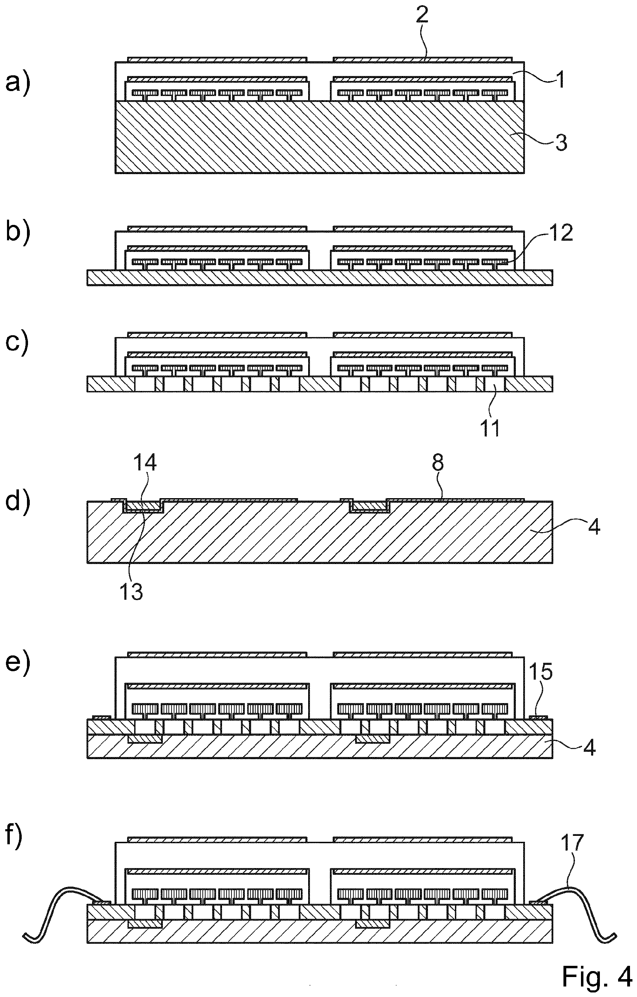

Eine besonders einfach herzustellende Ausgestaltung des Thermopile Arrays kommt komplett ohne TSVs (Vias) aus und ist in Fig. 4 dargestellt.

Die ersten vier Schritte erfolgen entsprechend wie in Fig. 3 a - d. Hier wird das Verfahren verkürzt in den Fig. 4a und b zusammengefasst.

Danach erfolgt der Rückseiten-Ätzschritt (Fig. 4c) bei dem die Kavitäten 11 zur thermischen Isolation der darüber liegenden Membranen für die Sensor-Pixel 5 entstehen, wobei keine Durchkontaktierungen vorbereitet werden. Der Bodenwafer 4 wird mit Kavitäten 13 für das Gettermittel 14 vorbereitet und dieses eingebracht (Fig. 4d) und mit den oberen beiden bereits aufeinander montierten Wafern verbunden und abgedünnt (Fig. 4e). Auf der Oberseite des zentralen Wafers 3 mit den Sensor-Pixeln 5 und der CMOS Signalverarbeitung 8 werden am Außenrand jedes Chips übliche Bondpads 15 aufgebracht.

Diese werden z.B. durch einen Sägeschnitt von oben mit einem breiteren Sägeblatt in den Waferverbund hinein freigelegt bevor der Verbund mit einem dünnen Sägeblatt in einzelne Chips zerlegt wird. Nach dem Freilegen der Bondpads 15 und vor dem Vereinzeln des Waferstapels können die Thermopile Arrays bereits im Waferverbund mit üblichen automatischen Waferprobern auf ihre Funktion getestet werden.

Im letzten Schritt (Fig. 4f) wird das vereinzelte Thermopile Sensor-Arraychip aus drei Teilwafern per üblicher Drahtbondverfahren mit Drahtbrücken 17 elektrisch mit externen Baugruppen verbunden. Über diese Drahtbrücken 17 und eine einfache Klebe- oder Lötverbindung kann das gesamte Arraychip, z.B. als Chip on Board auf eine Leiterplatte, in ein Keramik- oder Metallgehäuse, oder besonders bevorzugt in ein sogenanntes QFN Package mit sehr dünnem Boden montiert werden, um den Vorteil des flachen Gehäuses beizubehalten.

Das Grundprinzip des sehr dünnen Wafer Level Package für thermische Sensoren mit besonders kleinen Sensor-Pixeln 5 lässt sich auch für die Variante gestalten, bei der die Kavitäten 10, 11 zur thermischen Isolation der Sensor-Pixel 5 nicht von unten durch den zentralen Wafer geätzt werden, sondern von oben über an sich bekannte OpferschichtTechnologien (sogenanntes Surface Micromachining) eingebracht werden.

Eine solche Variante ist in Fig. 5 dargestellt, in der die Ausgestaltung des hochauflösenden Thermischen Sensors im Vakuum Wafer Level Package (WLP) mit drei Wafern dargestellt ist und bei dem das Herausätzen der Kavität 16 zur thermischen Isolation der Sensor-Pixel 5 von oberhalb des zentralen Wafers 3 durch bekannte Opferschichttechnologien erfolgt.

Darin wird beim zentralen Wafer 3 mit den thermisch sensitiven Sensor-Pixeln 5 (Fig. 5b) in an sich bekannter Opferschicht-Technologie durch Schlitze 11'' in der Membran 5'' eine Kavität 16 unter jedem Sensor-Pixel 5 erzeugt. Dies kann beispielsweise sowohl über an sich bekannte Opferschichten (wie poröses Silizium), oder als Oxid in SOI Technik oder auch durch anisotropisches Nassätzen des Bulk-Siliziums unter der Membran des Sensor-Pixels 5 erfolgen. Die herausgelösten Materialien werden durch die Schlitze 11'' in der Membran 5'' nach außen geleitet.

Die entstehenden Kavitäten 16 unter jedem Sensor-Pixel 5 sorgen dafür, dass die geschlitzte Membran 5" mit den Infrarot empfindlichen Funktionsschichten der Sensor-Pixel 5 gegenüber dem Siliziumsubstrat (zentraler Wafer 3) thermisch isoliert ist und unter der späteren Vakuum Atmosphäre ein hohes Sensorsignal ermöglicht.

Verwendet man u.a. das Verfahren des anisotropischen Ätzens, so ergibt sich bei sehr kleinen Pixeln (von z.B. < 50 µm) auch eine geringe Ätztiefe von nur wenigen 10 µm, so dass der zentrale Wafer 3 entsprechend stark abgedünnt werden kann, ohne dass die Kavität 16 nach außen zur Unterseite des zentralen Wafers 3 durchgeätzt wird, was einen Vakuumverschluss verhindern würde.

Bei der Montage wird in äquivalenter Art und Weise der zentrale Wafer 3 (Fig. 5b) mit dem Deckelwafer 1 (Fig. 5a) durch Waferbonden fest verbunden (Fig. 5c) und anschließend auf geringe Dicke abgedünnt (Fig. 5d). Wie bei dem vorangegangenen Ausführungsbeispiel in Fig. 3 werden elektrische Durchkontaktierungen 6 (TSVs) zwischen Vorder- und Rückseite des zentralen Wafers 3 mit den Sensor-Pixeln 5 oder den auf dem zentralen Wafer 3 integrierten ersten Stufen der Signalverarbeitungskanäle 8 vorgesehen (Fig. 5e). Außerdem sollte vorzugsweise mindestens ein Loch durch den zentralen Wafer geätzt werden (nicht dargestellt), oder eine oder mehrere Kavitäten 16 anisotrop durch den ganzen Wafer geätzt oder der Wafer so weit abgedünnt, dass die Kavitäten 16 freigelegt werden, damit das Gettermittel 14 in der Kavität 13 des Bodenwafers 4 (Fig. 5f) für ein stabiles Vakuum in den Kavitäten 10, 16 unterhalb und oberhalb der Sensor-Pixel 5 sorgen kann.

Prinzipiell kann das Gettermittel auch in der Kavität des Deckelwafers 10 mit den Filterschichten (siehe Fig. 6a) abgeschieden werden, allerdings ist im Bodenwafer 4 mehr Platz und es gibt auch weniger störende Effekte für die Sensor-Pixel 5 und die Filterschichten beim Aktivieren des Gettermittels 14.

Der Bodenwafer 4 mit den weiteren CMOS Signalverarbeitungskomponenten 8 wird mit dem Deckelwafer 1 und dem zentralen Wafer 3 durch übliches Waferbonden mechanisch fest und hermetisch dicht verbunden (Fig. 5g) und auf geringe Dicke abgedünnt, so dass auch dieser WLP Dreierverbund sehr dünn werden kann (< 0,5 bis < 1.0 mm).

Als Sonderform (abweichend von allen anderen Lösungen mit drei oder mehr Wafern im Verbund ergibt sich noch eine besonders einfache Ausgestaltung für ein Thermopile Array mit von oben eingeätzten Kavitäten 16, die in Fig. 6 dargestellt ist.

Fig. 6 zeigt eine Ausgestaltung des hochauflösenden Thermischen Sensors im Vakuum Wafer Level Package mit nur zwei Wafern, dem Deckelwafer 1 und dem zentralen Wafer 3, bei dem das Herausätzen der Kavität 16 zur thermischen Isolation der Sensor-Pixel 5 von oberhalb des zentralen Wafers 3 durch bekannte Opferschichttechnologien erfolgt.

Die ersten Schritte erfolgen äquivalent zur Variante nach Fig. 5. Im Gegensatz zur Lösung in Fig. 5 benötigt die in Fig. 6 gezeigte Ausgestaltung jedoch keine Durchkontaktierungen 6 und auch keinen Bodenwafer 4.

Ein Gettermittel 14 muss in diesem Fall möglichst am äußersten Rand der Kavität 10 des Deckelwafers 1 neben der Filterschicht 2 gegenüber den Sensor-Pixeln 5 eingebracht werden (Fig. 6a), damit der Blickwinkel des Sensorarrays nicht einschränkt wird.

Nach der Wafer-zu-Wafer Bondung von Deckelwafer 1 und dem zentralen Wafer 3 mit den Kavitäten 16 unter den Sensor-Pixeln 5 wird der (zentrale) Wafer 3 mit den Pixeln 5 im Verbund abgedünnt (Fig. 6b) und über Bondpads 15 am Chiprand und Kontaktbrücken 17 werden elektrische Kontakte zu einer Elektronik außerhalb des Array Chips geführt (Fig. 6c). Es versteht sich, dass hierfür eine Vielzahl von Bondpads 15 mit Drahtbrücken 17 erforderlich sein kann.

Auch wenn diese erfindungsgemäße Zwei-Wafer-Lösung sehr einfach erscheint, sei auf gewisse Nachteile gegenüber allen anderen erfindungsgemäßen Lösungen mit drei oder mehr Wafern hingewiesen:
- Die Integrationsdichte ist deutlich kleiner als bei den vorangegangenen Lösungen, da keine Signalverarbeitung auf den hier nicht vorhandenen Bodenwafer "ausgelagert" werden kann und das Gettermittel 14 in der Kavität 10 des Deckelwafers 1 neben der Filterschicht 2 untergebracht werden muss.
- Während die Enddicke des Arrays nach dem Abdünnen des (zentralen) Wafers 3 sehr gering sein kann (diese Aufgabe erfüllt die Lösung in Fig. 6), muss die laterale Abmessung des (zentralen) Wafers 3 größer sein, um auf diesem die komplette pixelseitige Signalverarbeitung unterzubringen. Dadurch vergrößert sich die Außenabmessung des Arraychips oder es lassen sich weniger Sensor-Pixel 5 auf einem Chip gleicher Größe unterbringen.
   - Wegen des geringeren Integrationsgrades ergeben sich folglich bei gleicher Baugröße Einbußen bei der Temperaturauflösung und / oder bei der räumlichen Auflösung (minimale Pixelgröße) als bei den vorangegangenen Lösungen.

Es empfiehlt sich bei dieser Variante, die Dicke des zentralen Wafers 3 weniger stark abzudünnen, bzw. ähnlich dick zu lassen wie bei der Kavität 10 des Deckelwafers 1. Damit entstehen weniger Probleme mit der Durchbiegung des Deckelwafers 1 und des zentralen Wafers 3 Chips infolge des Vakuums im Inneren.

In einer weiteren Ausführungsform kann der besonders flache "Sandwich" aus drei Wafern so ausgestaltet werden, dass er "oberflächenmontierbar" (SMD-fähig) wird (siehe Fig. 7).

Dabei müssen sowohl das Sensorchip im zentralen Wafer 3 als auch der Bodenwafer 4, mit an sich bekannten Durchkontaktierungen 6, 18 (TSV Vias) ausgestattet sein (Fig. 7a).

Solche Durchkontaktierungen 6, 18 können beim gegenwärtigen Stand der Technik laterale Abmessungen von wenigen µm haben. Voraussetzung hierfür sind sehr dünne Wafer. Dadurch können sie sowohl im Eckbereich der einzelnen Sensor-Pixel 5 untergebracht werden (was zur Verlagerung der kompletten pixelseitigen Signalverarbeitung 8 in den Bodenwafer 4 führen kann), als auch im Randbereich des zentralen Wafers 3 neben dem Pixelfeld (focal Plane), um einen Teil der Signalverarbeitung 8 in den Bodenwafer 4 zu legen.

Die Durchkontaktierungen 6 schließen jeweils mit nicht gesondert dargestellten Kontaktpads ab, so dass Durchkontaktierungen 18 (elektrische Kontakte) durch den Bodenwafer 4 zwischen beiden Wafern nach der Montage ermöglicht werden.

Die Rückseite des Bodenwafers 4 erhält Lothügel (Solder Bumps) 9, die auf die Durchkontaktierungen 18 des abgedünnten Bodenwafers 4 nach dem Abdünnen gesetzt werden (Fig. 7b).

Zum Erreichen der Oberflächenmontierbarkeit enthält der Bodenwafer 4
- Durchkontaktierungen 18 (TSVs) mit besonders kleinem Durchmesser von der Oberfläche mit den CMOS-Strukturen 8zur Unterseite des zentralen Wafers 3 und des Bodenwafers 4, von wo aus die Kontakte für das Interface zu externen Baugruppen der weiteren Signalverarbeitung bzw. zur Spannungsversorgung nach außen geführt werden;
- Lothügel 9 auf die unteren Enden der Durchkontaktierungen 18, um das Sensorchip (zentraler Wafer 3) mechanisch und elektrisch mit einem darunterliegenden Verdrahtungsträger (z.B. eine Leiterplatte - nicht dargestellt) zu verbinden.

Bei der Montage der drei Wafer sind allerdings einige Besonderheiten zu beachten:
So müssen die Wafer sehr genau zueinander ausgerichtet werden, was z.B. mithilfe von in Trockenätztechnik (DRIE) oder ähnlichen Ätzverfahren geätzten Löchern im Deckelwafer 1 erreicht werden kann, die den Vergleich von Justiermarken möglich macht. Dafür eignet sich auch ein Infrarot-Justageverfahren, weil die Silizium-Wafer für IR Strahlung transparent sind.

Für die präzise, lageorientierte Montage des Waferstapels beim SMD Prozess können ein Justageloch oder auch mehrere asymmetrische Löcher oder Kerben in den Ecken des oberen Deckelwafers 1 (Filterwafer) beitragen.

In einer speziellen Ausprägung wird im zentralen Wafer 3 in den Ecken jedes Sensor-Pixels 5 Durchkontaktierungen 6 zum darunterliegenden Bodenwafer 4 eingebracht, auf dem die CMOS Signalverarbeitung stattfindet.

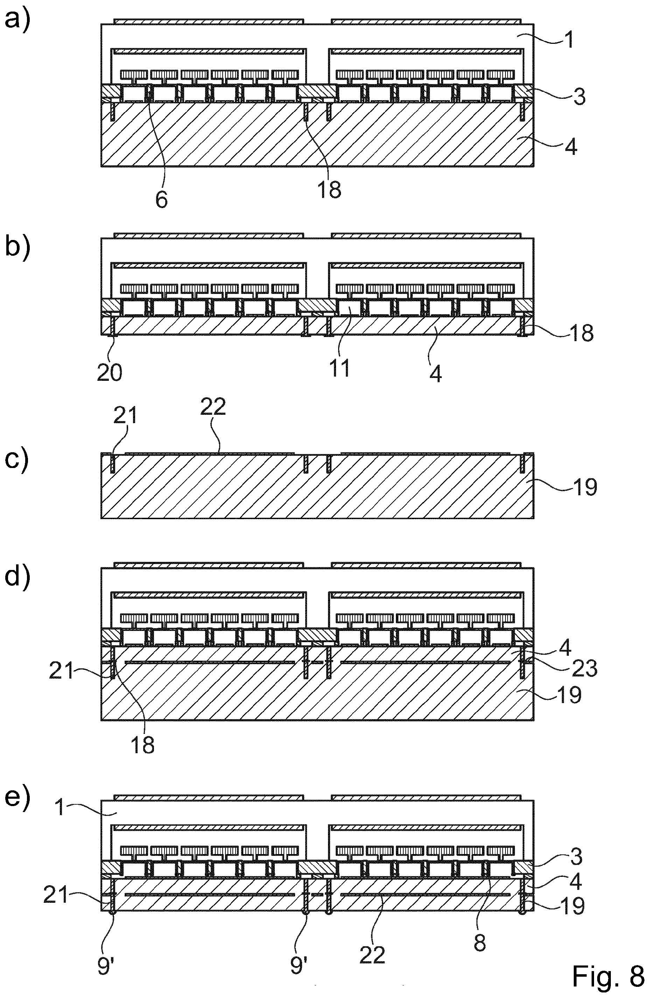

In einer weiteren speziellen Ausprägung kann unter dem Bodenwafer 4 mit der sensorseitigen (analog/digitalen) Signalverarbeitung ein weiterer Bodenwafer 19 (CMOS-Wafer) montiert werden (siehe Fig. 8). Dieser zusätzliche Bodenwafer 19 kann weitere Bildverarbeitungsfunktionen enthalten, z.B. einen Bildprozessor, große Datenspeicher oder andere digitale Rechenwerke. Damit kann der Sensorchip bei gleichen Außenabmessungen (Länge / Breite) und nur etwas größerer Dicke noch mehr Bildverarbeitungsfunktionen übernehmen.

Dazu wird der Waferstapel mit dem ursprünglichen Bodenwafer 4 vormontiert (Fig. 8a) und abgedünnt, wie bisher beschrieben. Nach der Kontaktformation werden aber keine Lothügel auf dem Bodenwafer 4 aufgebracht, sondern nur Kontaktpads 20, welche die spätere elektrische Verbindung zum zusätzlichen Bodenwafer 19 ermöglichen (Fig. 8b). Danach wird der zusätzliche Bodenwafer 19 mit zusätzlichen Signalverarbeitungskomponenten 22, wie z. B. Bildprozessoren oder größere digitale Bildspeicher zu den oberen Wafern justiert und im zweiten Bodenwafer 19 die zu Bodenwafer 4 passenden Durchkontaktierungen 21 formiert sowie entsprechende Vias für die finale elektrische Kontaktierung der gesamten Baugruppe des Waferstapels über Kontakthügel 9' am unteren Ende der Zwischenverbindungen 21 vorbereitet (Fig. 8e).

Die oberen Wafer und der zusätzliche Bodenwafer 19 werden durch übliche Waferbondmethoden mit dem Bodenwafer 4 mechanisch fest verbunden, und es erfolgt eine Kontaktbildung (Elektrische Zwischenverbindung) zwischen den aufeinander liegenden Waferseiten (Fig. 8d).

In den letzten Verfahrensschritten erfolgt das Abdünnen des zusätzlichen Bodenwafers 19 und die anschließende Formierung der Kontakthügel 9 für die SMD Montage (z.B. Lötzinn, leitfähige Kleber oder dgl.) siehe Fig. 8e).

Nach dem Abdünnen kann der so gebildete 4-fach Waferstapel eine Gesamtdicke von < 0,5...< 1 mm haben, weil der Deckelwafer 1 (Filterwafer) am dicksten verbleibt, während die drei darunter angeordneten Wafer jeweils im Verbund auf < 100 µm abgedünnt werden können, solange der Waferstapel insgesamt genügend mechanische Stabilität für das Waferhandling hat.

In Fig. 9 ist eine weitere Ausgestaltung des Thermopile Arrays im Wafer Level Package dargestellt, die auch ohne TSV auskommt. Im Gegensatz zu Fig. 4, die auch ohne TSV auskommt, ist hier allerdings aufgrund der geflippten Montage ein direkter elektrischer Kontakt über die jeweiligen Kontaktpads 25 des zentralen Wafers 3 und den Kontaktpads 24 des Bodenwafers 4 mit integrierter weiterführender Bildverarbeitung möglich (Fig. 9a, g). Damit ist es sogar möglich, die Auswertelektronik komplett auf dem Bodenwafer 4 zu integrieren und Platz für mehr Sensor-Pixel 5 freizumachen. Die Pixeldichte kann damit noch einmal erhöht werden.

Fig. 9 zeigt ein Thermopile Array im Wafer Level Package mit einem geflipptem, sehr stark abgedünnten zentralem Wafer 3, ohne Vias (Durchkontaktierungen) (Fig. 9a-f) und Fig. 9g eine vergrößerte Einzelheit mit einem Umbrella 7 auf der Membran 5".

Hierbei handelt es sich um eine besonders kostengünstige Variante. Dabei wird der Bodenwafer 4 mit der Vorderseite auf der Vorderseite des zentralen Wafers 3 positioniert. Beide Vorderseiten mit den jeweiligen Kontaktpads und einer Lotpaste o.ä. einen elektrischen Kontakt ergebenden Mitteln (nicht dargestellt) werden zueinander ausgerichtet. Dann wird der Bodenwafer 4 mit den Kontaktpads 24 auf dem Bodenwafer 4 direkt auf die Kontaktpads 25 auf dem zentralen Wafer 3 justiert (Fig. 9a). Danach werden beide Wafer durch übliche Waferbondmethoden mechanisch miteinander fest verbunden und der zentrale Wafer 3 anschließend sehr stark abgedünnt, idealerweise auf < 15µm (Fig. 9b).

Anschließend werden mittels DRIE die Kavitäten 11 für die Pixel eingetrieben und in diesen die dreidimensionale Absorberstruktur, d.h. die Umbrellas 7, eingebracht. (Fig. 9c). Der Deckelwafer 1 wird abgedünnt und die Kavitäten und die Filterschichten eingefügt (Fig. 9d). Danach wird der Deckelwafer 1 mit dem Waferverbund aus Bodenwafer 4 und zentralem Wafer 3 mit üblichen Waferbondmethoden mechanisch fest verbunden (Fig. 9e).

Anschließend wird der gesamte Waferverbund aus den drei Wafern geflippt, so dass der Bodenwafer 4 nun unten ist. (Fig. 9f). Nun kann der Chip auf einem geeigneten Untergrund platziert und verklebt werden und mittels Drahtbondbrücken 17 mit einem darunterliegenden Substrat (nicht dargestellt) elektrisch kontaktiert werden.

Auch das in vorigen Ausführungsformen genannte Aufbringen von Lothügeln ist möglich, um den Chip auf darunterliegende Substrate wie eine gedruckte Leiterplatte (PCB) o.ä. aufzubringen. Die Drahtbondbrücken 17 entfallen dabei.

Aufgrund dieser Methode sind keine Durchkontaktierungen erforderlich, da die CMOS Elektronik auf Boden- und Zentralem Wafer 4, 3 direkt über die jeweiligen Kontaktpads 24, 25 kontaktiert sind.

Zur Veranschaulichung ist in Fig. 9g ein Ausschnitt eines Pixelbereiches dargestellt. Der Umbrella 7 befindet sich auf der Membran 5" in der Kavität 11 des Sensor-Pixels 5 (im Gegensatz zu den bisherigen Ausführungen). Der Kontaktpad 24 des Bodenwafers 4 ist mit dem Kontaktpad 25 des zentralen Wafers 25 elektrisch verbunden. Auf dem Bodenwafer 4 befindet sich die Signalverarbeitung 8 (CMOS Processing).

Der Vollständigkeit halber sei erwähnt, dass prinzipiell auch weitere dünne Wafer zum Waferstapel hinzugefügt werden können. Eine stromsparende Halbleiter-Technologie, insbesondere für die Signalverarbeitungs- und Mikroprozessorschaltungen auf den unteren Wafern ist anzustreben, damit die Gesamtverlustleistung keine größeren Effekte auf die sogenannte Heat-Shock Problematik des thermisch sensitiven Wafers hat. Eine zu große Verlustleistung im Waferstapel führt zu langen Einschwingvorgängen nach dem Einschalten und zu Messfehlern.

Die in den Fig. 3 - 9 beschriebenen Ausführungsbeispiele mit Kavitäten 11, 16 die von der Vorderseite oder von der Rückseite her geätzt werden, für die Montage per Drahtbonden in COB-Technologie in QFN Packages oder eine automatische Montage per SMD sowie auch die Verwendung weiterer Bodenwafer 19 mit zusätzlichen Signalverarbeitungskomponenten können selbstverständlich beliebig miteinander kombiniert werden.

Mit sämtlichen beschriebenen Ausführungsformen wird die Aufgabe gelöst, ein besonders flaches, vakuumdichtes und mechanisch stabiles Thermopile Array aufzubauen.

Außerdem haben die Ausführungsbeispiele - außer den vereinfachten Varianten in Fig. 4 und Fig. 6 - zwei wesentliche Vorteile gegenüber dem Stand der Technik:
- Einerseits kann fast die gesamte Fläche des zentralen Wafers 3 für die Sensor-Pixel 5 selbst genutzt werden, während die ebenfalls erforderliche beträchtliche Fläche für die Signalverarbeitungskanäle 8 auf dem darunterliegenden Bodenwafer 4 angeordnet ist. So wird die kleinstmögliche Abmessung des Sensor-Sandwiches erreicht, was wiederum ein Vorteil für kleine IR-Kameramodule in sogenannten "mobile Devices" (wie Smartphones) ist, die einem besonders hohen Integrationsgrad bzw. hohe Packungsdichte erreichen.
- Andererseits kann der zentrale Wafer 3 mit den Sensor-Pixeln 5 in einer Technologie hergestellt werden, die besonders auf Thermopile-Strukturen zugeschnitten ist, während der (oder die weiteren) Bodenwafer 4, 19 in einer "Mixed Signal" CMOS Technologie hergestellt werden kann, die keine speziellen Thermopile Strukturen integrieren muss, oder auf diese Rücksicht nehmen muss.

Nach Fig. 9 ist es aufgrund der geflippten Montage sogar möglich, die gesamte Signalverarbeitung auf dem unteren Bodenwafer 19 unterzubringen

Die zweite Aufgabe eines besonders hochauflösenden Thermopile Arrays (räumlich und thermisch) wird durch drei erfindungsgemäße Maßnahmen gelöst:
- Der zentrale Wafer 3 hat v.a. bei den Lösungen mit von der Waferrückseite geätzter Kavität 11 (also nach Fig. 3, 4, 7 und 8, 9) nach dem Abdünnen auf eine derart geringe Restdicke, dass es möglich ist, damit viel kleinere Thermopile Pixel als bisher bekannt aufzubauen, d.h. die nach dem DRIE Ätzen verbleibenden Si-Ränder der Sensor-Pixel 5 um die Kavitäten 11 (die zur thermischen Trennung und als Wärmesenke für die kalten Kontakte dienen) können auf wenige Mikrometer reduziert werden. Dadurch wird die verbleibende Membrangröße im Verhältnis zur Pixelabmessung größer, bzw. kleinere Pixel werden möglich (beispielsweise < 25...50 µm).
- Über sehr kleine Durchkontaktierungen 6 (mit geringem Durchmesser) werden die Signalelektroniken (ROIC) bevorzugt auf dem Bodenwafer 4, 19 untergebracht. Dort ist mehr Platz als neben dem Thermopile Array auf dem zentralen Wafer 3. Im Idealfall kann fast die gesamte Chipfläche für das Focal Plane Array genutzt werden. (Fig.9)
- Wird der Bodenwafer 4 (oder wie in Fig. 5, 7 und 8 ein weiterer Bodenwafer 19) mit nahezu der gesamten Chipfläche für die Signalverarbeitungskanäle (SVK) nutzbar, so müssen sich bei einem hochauflösenden Array weniger Sensor-Pixel 5 einen Signalverarbeitungskanal teilen, oder es bleibt mehr Fläche für einzelne Vorverstärker. Während die größere Zahl parallel arbeitender SVK die Rauschbandbreite senkt, verringert sich das Rauschen des Vorverstärkers bei größerer Fläche. Beide Maßnahmen reduzieren das Rauschen und verbessern die rauschbegrenzte Temperaturauflösung der Pixel (NETD).

Die Funktionsweise wird an einem thermischen Arraysensor mit Thermopilepixeln kurz erläutert. Prinzipiell gilt das Nachfolgende sinngemäß auch für andere thermische Sensorprinzipien wie pyroelektrische Sensoren oder Mikrobolometer.

Die Thermopile-Strukturen werden in bekannter Weise auf einem Siliziumchip integriert, das auf einem Wafer hergestellt wird (dem zentralen Wafer 3 mit den Sensor-Pixeln 5). Ein Thermopile Array enthält eine große Zahl von einzelnen Sensor-Pixeln 5, die üblicherweise in Matrixform in Zeilen und Spalten angeordnet sind.

Spezielle CMOS- kompatible Verfahren der Mikrosystemtechnik führen nach dem eigentlichen CMOS-Prozess zur Herstellung der Sensor-Pixel 5, die sich beispielsweise auf einer dünnen dielektrischen Schicht, wie Siliziumdioxid, Siliziumnitrid, -karbid oder deren Kombination, befinden.

Nach dem CMOS Prozess des zentralen Wafers 3 findet der MEMS Prozess statt. In der ersten Phase des MEMS Prozesses (noch vor der Montage mit dem Deckelwafer 1) werden die Passivierungsschichten über den Thermoelementen abgedünnt und die späteren Schlitze 11'' zur thermischen Isolation der Beams 11' von der Waferoberseite bis zur Silizium Bulk Grenze eingetrieben. Das erfolgt üblicherweise durch sogenanntes Trockenätzen oder ähnliche anisotrope Verfahren.

Der Zentralteil der Membran 5" wird mit einer Infrarot-Absorberschicht ausgestattet (Fig. 2d). Vorzugsweise werden dafür dreidimensionale Umbrellas 7 (Schirmstrukturen) erzeugt, um dem Sensor-Pixel 5 einen besonders hohen Füllgrad zu verleihen (Fig. 2e). Auf den Umbrellas 7 können zusätzliche Absorberschichten aufgebracht werden, um die Infrarotempfindlichkeit weiter zu erhöhen.

Die weiteren MEMS Schritte erfolgen erst nach der Montage von Deckelwafer 1 und dem zentralen Wafer (Fig. 3a-c) durch bekannte Verfahren des Waferbondens.

Die Ätzung der Kavitäten 11 unter den Thermopile Sensor-Pixeln 5 (Fig. 3e) erfolgt bei allen Varianten mit idealerweise rückseitig geätzter Kavität 11 unter den Pixeln erst nachdem der zentrale Wafer 3 bzw. der Wafer mit den Sensorpixeln 5 im Waferverbund mit dem Deckelwafer 1 auf geringe Dicke abgedünnt ist, um die Präzision der Ätzgenauigkeit zu erhöhen. Grundsätzlich ist aber auch eine Ätzung an anderer Stelle möglich, falls es insbesondere CMOS-Kompatibilitätsanforderungen von Waferfabriken erlauben und das sichere Waferhandling gewährleistet ist.

Nach dem Abdünnen des zentralen Thermopile-Wafers 3 (Fig. 3d) erfolgt das erfindungsgemäße Hineintreiben der Kavität 11 in den bereits stark (typisch < 50...100 µm) abgedünnten zentralen Wafer 3 von der Rückseite (Fig. 3e) durch DRIE Trockenätzen.

Nach der zweiten MEMS Phase entstehen auf der Vorderseite des zentralen Wafers 3 freitragende dünne Membranen 5'' aus den genannten dielektrischen Schichten und Isolationsschlitzen 11'' für die Stege (Beams 11'), die neben der thermischen Isolation für die sensitiven IR-Pixel später auch den Gasaustausch (Vakuum zwischen Ober- und Unterseite der Sensor-Pixel und die Wirksamkeit des Getters ermöglichen (z.B. Fig. 3f und g), wie bereits beschrieben.

Auf den Membranen 5'' im Zentrum der Thermopile Sensor-Pixel 5 befinden sich heiße Kontakte sowie die thermoelektrischen Elemente. Zwischen dem Gebiet der heißen Kontakte im Zentralteil der Membran 5'' und der Siliziumsenke werden die Thermoelemente auf Beams 11' (schmale Verbindungselemente) geführt, welche durch die Schlitze 11'' in der Membran 5'' vom Zentralteil der Membran 5'' und der Siliziumsenke (das die Kavität 11 umgebende Siliziummaterial) thermisch isoliert sind und so ein Wärmetransport von den heißen Kontakten auf der Membran 5'' zur Siliziumsenke hin verringert wird.

Für die Thermoelemente kommen Halbleitermaterialien mit einem hohen Seebeck- Koeffizienten in Frage. Polysilizium, Amorphe Siliziumschichten, SiGe - Schichten als auch speziell implantierte Schichten mit hohem thermoelektrischem Koeffizienten (wie Wismut oder Antimon und deren Verbindungen) sind möglich.

Der Deckelwafer 1 besteht bevorzugt wie alle anderen darunter liegenden Wafer aus Silizium, weil dann alle Wafer den gleichen thermischen Ausdehnungskoeffizienten aufweisen, prinzipiell sind aber auch andere Materialien, wie Glassubstrate oder andere organische und anorganische Materialien, möglich um den Anforderungen an die nötigen optischen Eigenschaften zu genügen (z.B. Ge oder auch sogenannte Chalcogenide).

Der Bodenwafer 4, 19 ist vorzugsweise aus Silizium hergestellt, kann aber auch aus anderen Materialien wie Glas bestehen - mit dem Nachteil eines geringeren Integrationsgrades, weil dann keine oder viel weniger Signalverarbeitungsfunktionen integriert werden können, als das bei Siliziumwafern möglich ist. Ebenso kann der Bodenwafer 4, 19 aus organischen Materialien bestehen und beispielsweise eine organische Elektronik enthalten, um den Einsatz auf flexiblen Trägern, wie in faltbaren Smartphones, zu vereinfachen.

Auf die an sich bekannten Prozesse und Anordnungen bei der Herstellung und Montage der einzelnen Wafer wurde hier bewusst nur sehr kurz eingegangen, da diese bereits bekannt sind.

Das vakuumgefüllte Waferlevel Gehäuse versteht sich als evakuiertes Waferlevel Gehäuse, oder als Waferlevel Gehäuse in dem ein Vakuum herrscht.

### Bezugszeichenliste

- 1: oberer Deckelwafer
- 1': Steg
- 2: Filterschicht
- 3: zentraler Wafer
- 4: Bodenwafer
- 5: Sensor-Pixel
- 5': Streifen
- 5": Membran
- 6: Durchkontaktierung
- 7: Umbrella (Strahlungskollektor)
- 8: CMOS Signalverarbeitungskanäle
- 9: Kontakthügel
- 9': Kontakthügel
- 10: Kavität im Filterwafer
- 11: Kavität
- 11': Beam
- 11": Schlitz
- 12: Pixel mit Umbrella
- 13: Kavität
- 14: Gettermittel
- 15: Bondpad
- 16: Kavität
- 17: Drahtbrücke
- 18: Durchkontaktierung
- 19: zusätzlicher Bodenwafer
- 20: Kontaktpad
- 21: Kontaktpad
- 22: Signalverarbeitung
- 23: Kontaktpad
- 24: Kontaktpad
- 25: Kontaktpad

## Patentansprüche

1. Verfahren zum Herstellen eines hochauflösenden thermischen Infrarot-Sensor Arrays in einem vakuumgefüllten Waferlevel Gehäuse mit besonders kleinen Abmessungen, das aus mindestens zwei Wafern, einem Deckelwafer (1) und einem zentralen Wafer (3) mit einer Vielzahl von sensitiven infrarotempfindlichen Sensor-Pixeln (5) mit einer Größe von < 50 µm auf je einer dünnen, geschlitzten Membran (5'') über einer wärmeisolierenden Kavität (11) in dem zentralen Wafer (3) besteht,
wobei der Deckelwafer (1) auf der Innenseite mit mindestens einer Kavität (10) versehen wird, deren Tiefe einige 10 µm bis zur Hälfte der Gesamtdicke des Deckelwafers (1) entspricht und mit dem vorbereiteten zentralen Wafer (3) mit den Infrarot empfindlichen Pixeln (5) durch Waferbonden mechanisch fest verbunden wird,
wobei der zentrale Wafer (3) nachfolgend von der Waferrückseite her auf eine vorgegebene Dicke von weniger als 200 µm abgedünnt wird,
wobei Tiefenätzungen zur Herstellung von jeweils einer Kavität (11) unter jedem Pixel (5) nach dem Abdünnen des zentralen Wafers (3) vorgenommen werden, und
wobei nach dem Abdünnen des zentralen Wafers (3) mindestens ein Bodenwafer (4) durch Waferbonden auf dessen Rückseite befestigt und danach abgedünnt wird.

2. Verfahren nach Anspruch 1, **gekennzeichnet dadurch, dass** die wärmeisolierende Kavität (11) unter der geschlitzten Membran (5'') jedes infrarotempfindlichen Sensor-Pixels (5) von der Vorderseite aus durch die Schlitze (11'') in der Membran (5") in den zentralen Wafer (3) geätzt wird, nachdem der zentrale Wafer (3) auf eine vorgegebene Dicke abgedünnt worden ist.

3. Verfahren nach Anspruch 1, **gekennzeichnet dadurch, dass** die wärmeisolierende Kavität (11) unter der Membran (5'') jedes infrarotempfindlichen Pixels (5) von der Rückseite her in den zentralen Wafer (3) geätzt wird, nachdem der zentrale Wafer (3) auf eine vorgegebene Dicke abgedünnt worden ist.

4. Verfahren nach einem der vorgenannten Ansprüche, **gekennzeichnet dadurch, dass** auf dem zentralen Wafer (3) neben den Sensor-Pixeln (5) mindestens ein Teil der Signalvorverarbeitung der Sensorpixel integriert wird.

5. Verfahren nach einem der vorgenannten Ansprüche, **gekennzeichnet dadurch, dass** nach dem Abdünnen in den zentralen Wafer (3) Durchkontaktierungen (6) mit besonders geringen lateralen Abmessungen von der Vorderseite zur Rückseite des zentralen Wafers (3) eingebracht werden.

6. Verfahren nach einem der vorgenannten Ansprüche, **gekennzeichnet dadurch, dass** der oder die Bodenwafer (4) nach dem Waferbonden auf eine Dicke von weniger als 300 µm abgedünnt werden.

7. Verfahren nach einem der vorgenannten Ansprüche, **gekennzeichnet dadurch, dass** der Bodenwafer (4) mit einem Teil der Signalverarbeitung des Sensorarrays versehen wird.

8. Verfahren nach einem der vorgenannten Ansprüche, **gekennzeichnet dadurch, dass** der Bodenwafer (4) mit Durchkontaktierungen (18) von der Vorderseite zur Rückseite versehen wird.

9. Verfahren nach einem der vorgenannten Ansprüche, **gekennzeichnet dadurch, dass** der jeweils zuunterst liegende Bodenwafer (4) auf dessen Unterseite mit Metallisierungen versehen wird, die ihn zur SMD Montage durch Löten, Schweißen oder Kleben befähigen.

10. Verfahren nach einem der vorgenannten Ansprüche, **gekennzeichnet dadurch, dass** der Bodenwafer (4) mit mindestens einer Kavität (10) versehen wird, in die ein Gettermittel (14) zur Stabilisierung eines Vakuums eingebracht wird und dass durch dieses Gettermittel (14) nach seiner späteren Aktivierung durch eine Perforation in den Sensor-Pixeln (5) oder mindestens ein zusätzliches Loch im zentralen Wafer (3) die Hermetizität einer Kavität (10) im Deckelwafer (1) über den Sensor-Pixeln (5) gesichert wird.

11. Verfahren nach einem der vorgenannten Ansprüche, **gekennzeichnet dadurch, dass** unter dem Bodenwafer (4) mindestens ein weiterer Bodenwafer (4') angeordnet wird, der weitere Signalverarbeitungskomponenten, Bildprozessoren oder Chips für künstliche Intelligenz enthält.

12. Verfahren nach einem der vorgenannten Ansprüche, **gekennzeichnet dadurch, dass** der Deckelwafer (1) aus einem Infrarot durchlässigen Material, wie Silizium, Germanium, Zinksulfid, Chalcogenid oder einem Polymer gefertigt wird.

13. Verfahren nach einem der vorgenannten Ansprüche, **gekennzeichnet dadurch, dass** auf beiden Seiten des Deckelwafers (1) infrarotdurchlässige Antireflex- oder Filterschichten aufgebracht werden.

14. Verfahren nach Anspruch 13, **gekennzeichnet dadurch, dass** die infrarotdurchlässigen Antireflexschichten mit einer Langpass- oder Bandpassbeschichtung versehen werden, um vorgegebene Wellenlängenbereiche zu blockieren.

15. Verfahren nach einem der Ansprüche 5 bis 14, **gekennzeichnet dadurch, dass** die Durchkontaktierungen (6) des zentralen Wafers (3) mit den Kontaktpads (20) auf der Vorderseite des Bodenwafers (4) mit Durchkontaktierungen (18) des Bodenwafers (4) sowie mit Durchkontaktierungen (21) eines zusätzlichen Bodenwafers (19) mechanisch und elektrisch verbunden und nachfolgend abgedünnt wird, sowie dass die Durchkontaktierungen (21) im zusätzlichen Bodenwafer (19) mit Kontaktpads (9') versehen werden.

## Claims

1. Method for fabricating a high-resolution thermal infrared sensor array in a vacuum-filled wafer-level package with particularly small dimensions, which consists of at least two wafers, a cover wafer (1) and a central wafer (3) with a plurality of sensitive infrared-sensitive sensor pixels (5) with a size of < 50 µm each on a thin, slotted membrane (5'') above a heat-insulating cavity (11) in the central wafer (3),
wherein the lid wafer (1) is provided on the inside with at least one cavity (10), the depth of which corresponds to some 10 µm to half the total thickness of the lid wafer (1) and is mechanically firmly connected to the prepared central wafer (3) with the infrared-sensitive pixels (5) by wafer bonding,
whereby the central wafer (3) is subsequently thinned from the back of the wafer to a predetermined thickness of less than 200 µm,
wherein depth etchings are made to produce one cavity (11) under each pixel (5) after thinning the central wafer (3), and
wherein, after thinning the central wafer (3), at least one bottom wafer (4) is fixed to the back of the wafer by wafer bonding and then thinned.

2. Method according to claim 1, **characterized in that** the heat-insulating cavity (11) under the slit membrane (5'') of each infrared-sensitive sensor pixel (5) is etched into the central wafer (3) from the front side through the slits (11'') in the membrane (5'') after the central wafer (3) has been thinned to a predetermined thickness.

3. Method according to claim 1, **characterized in that** the heat-insulating cavity (11) under the membrane (5'') of each infrared-sensitive pixel (5) is etched into the central wafer (3) from the rear side after the central wafer (3) has been thinned to a predetermined thickness.

4. Method according to any of the preceding claims, **characterized in that** at least part of the signal preprocessing of the sensor pixels is integrated on the central wafer (3) in addition to the sensor pixels (5).

5. Method according to any of the preceding claims, **characterized in that**, after thinning, vertical interconnect accesses (6) with particularly small lateral dimensions are introduced into the central wafer (3) from the front side to the rear side of the central wafer (3).

6. Method according to any of the preceding claims, **characterized in that** the bottom wafer or wafers (4) are thinned to a thickness of less than 300 µm after wafer bonding.

7. Method according to any of the preceding claims, **characterized in that** the bottom wafer (4) is provided with a part of the signal processing of the sensor array.

8. Method according to any of the preceding claims, **characterized in that** the bottom wafer (4) is provided with vertical interconnect accesses (18) from the front side to the rear side.

9. Method according to any of the preceding claims, **characterized in that** the bottom wafer (4) lying at the bottom in each case is provided on its underside with metallizations which enable it to be SMD mounted by soldering, welding or gluing.

10. Method according to any of the preceding claims, **characterized in that** the bottom wafer (4) is provided with at least one cavity (10) into which a getter means (14) for stabilizing a vacuum is introduced, and **in that** this getter means (14), after its subsequent activation by a perforation in the sensor pixels (5) or at least one additional hole in the central wafer (3), ensures the hermeticity of a cavity (10) in the top wafer (1) above the sensor pixels (5).

11. Method according to any of the preceding claims, **characterized in that** at least one further bottom wafer (4') is arranged under the bottom wafer (4), which contains further signal processing components, image processors or chips for artificial intelligence.

12. Method according to any of the preceding claims, **characterized in that** the lid wafer (1) is made of an infrared-transmissive material, such as silicon, germanium, zinc sulphide, chalcogenide or a polymer.

13. Method according to any of the preceding claims, **characterized in that** infrared- transmissive anti-reflective or filter layers are applied to both sides of the cover wafer (1).

14. Method according to claim 13, **characterized in that** the infrared-transmissive anti-reflective layers are provided with a long-pass or band-pass coating in order to block predetermined wavelength ranges.

15. Method according to any of claims 5 to 14, **characterized in that** the vertical interconnect accesses (6) of the central wafer (3) are mechanically and electrically connected to the contact pads (20) on the front side of the bottom wafer (4) with vertical interconnect accesses (18) of the bottom wafer (4) and with vertical interconnect accesses (21) of an additional bottom wafer (19) and subsequently thinned, and **in that** the vertical interconnect accesses (21) in the additional bottom wafer (19) are provided with contact pads (9').

## Revendications

1. Procédé de fabrication d'un réseau de capteurs infrarouges thermiques à haute résolution dans un boîtier à niveau de plaquette rempli sous vide, qui consiste en au moins deux plaquettes, une plaquette de couverture (1) et une plaquette centrale (3) avec une pluralité de pixels de capteurs infrarouges sensibles (5) d'une taille < 50 µm chacun sur une membrane mince et fendue (5'') au-dessus d'une cavité thermo-isolante (11) dans la plaquette centrale (3),
dans lequel la plaquette de couverture (1) est pourvue à l'intérieur d'au moins une cavité (10) dont la profondeur correspond à quelques 10 µm à la moitié de l'épaisseur totale de la plaquette de couverture (1) et est fermement reliée mécaniquement à la plaquette centrale préparée (3) avec les pixels sensibles aux infrarouges (5) par soudage des plaquettes,
dans lequel la plaquette centrale (3) est ensuite amincie à partir de l'arrière de la plaquette jusqu'à une épaisseur prédéterminée de moins de 200 µm,
dans lequel des gravures en profondeur sont effectuées pour produire une cavité (11) sous chaque pixel (5) après l'amincissement de la plaquette centrale (3), et
dans lequel, après l'amincissement de la plaquette centrale (3), au moins une plaquette de fond (4) est fixée à l'arrière de la plaquette par soudage des plaquettes, puis amincie.

2. Procédé selon la revendication 1, **caractérisé en ce que** la cavité thermo-isolante (11) sous la membrane fendue (5'') de chaque pixel de capteur sensible aux infrarouges (5) est gravée dans la plaquette centrale (3) depuis la face avant à travers les fentes (11'') dans la membrane (5'') après que la plaquette centrale (3) a été amincie jusqu'à une épaisseur prédéterminée.

3. Procédé selon la revendication 1, **caractérisé en ce que** la cavité thermo-isolante (11) sous la membrane (5'') de chaque pixel sensible aux infrarouges (5) est gravée dans la plaquette centrale (3) à partir de la face arrière après que la plaquette centrale (3) a été amincie à une épaisseur prédéterminée.

4. Procédé selon l'une des revendications précédentes, **caractérisé en ce qu'**au moins une partie du prétraitement du signal des pixels du capteur est intégrée sur la plaquette centrale (3) en plus des pixels du capteur (5).

5. Procédé selon l'une des revendications précédentes, **caractérisé en ce qu'**après l'amincissement, des accès d'interconnexion verticaux (6) ayant des dimensions latérales particulièrement petites sont introduits dans la plaquette centrale (3) de la face avant à la face arrière de la plaquette centrale (3).

6. Procédé selon l'une des revendications précédentes, **caractérisé en ce que** la ou les plaquettes de fond (4) sont amincies jusqu'à une épaisseur inférieure à 300 µm après le soudage des plaquettes.

7. Procédé selon l'une des revendications précédentes, **caractérisé en ce que** la plaquette de fond (4) est munie d'une partie du traitement du signal du réseau de capteurs.

8. Procédé selon l'une des revendications précédentes, **caractérisé en ce que** la plaquette de fond (4) est pourvue d'accès d'interconnexion verticaux (18) de la face avant à la face arrière.

9. Procédé selon l'une des revendications précédentes, **caractérisé en ce que** la plaquette de fond (4) située respectivement tout en bas est pourvue, sur sa face inférieure, de métallisations qui la rendent apte au montage CMS par brasage, soudage ou collage.

10. Procédé selon l'une des revendications précédentes, **caractérisé en ce que** la plaquette de fond (4) est pourvue d'au moins une cavité (10) dans laquelle est introduit un moyen d'obturation (14) pour stabiliser le vide, et **en ce que** ce moyen d'obturation (14), après son activation ultérieure par une perforation dans les pixels du capteur (5) ou par au moins un trou supplémentaire dans la plaquette centrale (3), assure l'herméticité d'une cavité (10) dans la plaquette de couverture (1) au-dessus des pixels du capteur (5).

11. Procédé selon l'une des revendications précédentes, **caractérisé en ce qu'**au moins une autre plaquette de fond (4') est disposée sous la plaquette de fond (4), qui contient d'autres composants de traitement des signaux, des processeurs d'images ou des puces pour l'intelligence artificielle.

12. Procédé selon l'une des revendications précédentes, **caractérisé en ce que** la plaquette de couverture (1) est constituée d'un matériau transmissible par infrarouge, tel que le silicium, le germanium, le sulfure de zinc, le chalcogénure ou un polymère.

13. Procédé selon l'une des revendications précédentes, **caractérisé en ce que** des couches antireflets ou filtrantes transmissibles par infrarouge sont appliquées sur les deux faces de la plaquette de couverture (1).

14. Procédé selon la revendication 13, **caractérisé en ce que** les couches antireflets transmissibles par infrarouge sont pourvues d'un revêtement à passage long ou à passage de bande afin de bloquer des gammes de longueurs d'onde prédéterminées.

15. Procédé selon l'une des revendications 5 à 14, **caractérisé en ce que** les accès d'interconnexion verticaux (6) de la plaquette centrale (3) sont reliés mécaniquement et électriquement aux plots de contact (20) sur la face avant de la plaquette de fond (4) par des accès d'interconnexion verticaux (18) de la plaquette de fond (4) et par des accès d'interconnexion verticaux (21) d'une plaquette de fond supplémentaire (19), et qu'ils sont ensuite amincis, et **en ce que** les accès verticaux d'interconnexion (21) de la plaquette de fond supplémentaire (19) sont pourvus de plots de contact (9').
